# EUROPÄISCHE PATENTSCHRIFT

(11) **EP 3 564 703 B1**
(45) Veröffentlichungstag und Bekanntmachung des Hinweises auf die Patenterteilung: **31.12.2025**
(21) Anmeldenummer: 19166608.0
(22) Anmeldetag: 01.04.2019
(51) Int. Cl.: G01S 7/487, G01S 7/486

(54) **VERFAHREN ZUR VERBESSERUNG DER LAUFZEIT- UND/ODER PHASENMESSUNG**
METHOD FOR IMPROVING RUNTIME AND/OR PHASE MEASUREMENT
PROCÉDÉ D'AMÉLIORATION DE LA MESURE DE TEMPS DE MARCHE ET/OU DE PHASE

(30) Priorität: 30.04.2018 EP 18170172
(43) Veröffentlichungstag der Anmeldung: 06.11.2019
(73) Patentinhaber: Lambda: 4 Entwicklungen GmbH, 22299 Hamburg (DE)
(72) Erfinder: REIMANN, Rönne, 22769 Hamburg (DE)
(74) Vertreter: Raffay & Fleck

(56) Entgegenhaltungen:
- EP-A1- 2 942 644
- WO-A1-2009/129552
- WO-A1-2011/076907
- US-A1- 2003 021 186

## Beschreibung

Verfahren zur Verbesserung der Laufzeit- und/oder Phasenmessung und/oder zur Synchronisierung in digitalen Übertragungssystemen.

Es ist bekannt, zur Entfernungsmessung eine Laufzeitmessung des Signals zu verwenden. Dazu wird in die Regel die Phasenverschiebung oder Flugzeit eines Signals gemessen.

Aus reinen Entfernungsmesssystemen, die die Laufzeit eines Signalpulses auswerten, ist es beispielsweise aus der EP 3 098 626 A1 bekannt, beim Eintreffen des Signals über einen Komparator einen Signalgenerator zu starten der eine auch wiederholte Flanke generiert und durch Abtastung der Flanke auf den Zeitpunkt des Eintreffen des Pulses zurückzuschließen. Andere Methoden zur Bestimmung des Eintreffen eines Pulses sind zum Beispiel bekannt aus der EP 2 942 644 A1, US 2003/021,186 A1, WO 2009/129,552 A1 und WO 2011/076,907 A1.

Aus einem anderen Gebiet der Technik ist es aus der US2018/113160 bekannt, das Verhältnis von Abtastwerten eines Signalpuls eines Szintillators und ein Nachschlagewerk zu verwenden, um daraus die genaue zeitliche Lage des den Puls auslösenden Ereignisses zu schätzen.

Ebenfalls aus einem anderen Gebiet der Technik ist es aus der US 5 745 464 bekannt, unter Analyse der Flanken eines Signals generiert bei der Auslesung von optischen Datenträgern auch unter thermischen Einflüsse eine Korrektur der digitalen Daten zu erreichen, um möglichst genau die ursprünglich auf dem Datenträger codierten Daten auszulesen.

Anders als in Entfernungsmessern, die die Laufzeit eines zur Laufzeitmessung generierten Pulses verwenden, um bei direkter Sichtverbindung aus der Rundlaufzeit des reflektierten Pulses verwenden, um die Entfernung zu bestimmen werden in digitale Systeme, die zur Datenübertragung genutzt werden, die digitalen Daten durch bestimmte Verfahren in meist elektromagnetische Signale zur Übertragung umgewandelt, übertragen und beim Empfänger wieder decodiert. Dazu werden verschiedene Codier- und/oder Modulationsverfahren, teilweise mit Signalformungsverfahren eingesetzt. In der Regel werden die Daten auf ein niederfrequentes analoges Signal aufmoduliert und wird dieses Signal dann mit einer höheren Frequenz gemischt. Beim Empfänger werden dann die digitalen Daten wieder aus dem hochfrequenten Signal extrahiert. Dazu wird in der Regel mittels Mischer zunächst auf eine niedrige oder mittlere Frequenz transformiert, um anschließend die Daten zu extrahieren. Genutzt werden dazu beispielsweise Verfahren wie PSK (Phasenumtastung), FSK (Frequenzumtastung) auch in der Form GFSK (Gaußsche Frequenzumtastung) und/oder I&Q (In-Phase-&-Quadrature-Verfahren) oder QAM (Quadraturamplitudenmodulation).

Aber auch bei Übertragungen über Kabel oder Lichtleiter kommen oben genannte oder ähnliche Verfahren zur Codierung der Information teilweise zum Einsatz.

Am Empfänger wird ein Analog-Digital-Wandler verwendet, mit Hilfe dessen die digitalen Signale zurück gewonnen werden. Dabei werden üblicherweise die zunächst mit dem Analog-Digital-Wandler gewonnen Informationen über den tatsächlichen analogen Signalverlauf größtenteils verworfen und allein die digitale Information weiterverarbeitet, die mit größter Wahrscheinlichkeit in dem analogen Signal codiert war. Dazu sind zahlreiche Techniken bekannt, die Wahrscheinlichkeiten zu beeinflussen bzw. zu verschieben, und die Übertragungssicherheit und/oder Menge der Daten pro Zeit und/oder pro Bandbreite zu optimieren.

Dies ist jedoch nicht Gegenstand der Erfindung. Vielmehr ist es ihre Aufgabe, durch gezielte Nutzung des analogen Signals, das zur Datenübertragung, insbesondere von Nutzdaten, oder die zunächst mit dem Analog-Digital-Wandler gewonnen Informationen über das analoge Signal, das beispielsweise über ein Kabel, einen Lichtleiter und/oder per Funk übertragen wurde, die, insbesondere zeitliche, Lage des Signal und/oder die Phasenlage des Signals zu ermitteln und/oder Zeiten zu synchronisieren und zwar mit höherer Genauigkeit, als dies in bestehenden System, insbesondere zur Übertragung digitaler Daten, möglich ist, insbesondere ohne die Anforderungen an die Hardware weiter zu erhöhen. Mit besonderem Vorteil geschieht dies mittels eines analogen Signals, in dem digitale Informationen codiert sind, insbesondere einem vorbekannten.

Dazu macht sich die Erfindung im Gegensatz zum Vorgehen bei bekannten Übertragungssystemen, die in der Regel mit einer Schwellenwertentscheidung zur Decodierung der Information aus einem Signal arbeiten, den genauen Signalverlauf zu Nutze, um die, insbesondere zeitliche, Lage des empfangenen Signals zu bestimmen. Schwellenwertentscheidungen zeigen nämlich eine deutliche Abhängigkeit von der Abtastrate bzw. der Lage der Abtastungen relativ zum Signalverlauf, wohingegen durch Nutzung des tatsächlichen Werts der Abtastung eine deutlich genauere Bestimmung der, insbesondere zeitlichen, Lage des Signals möglich ist.

Zwar ist die zeitliche Lage des Abtastwertes gemessen gegen eine absolute Zeit oder einen Taktgeber am zweiten Objekt wohl durch die Abtastung bekannt, doch ist die Lage des Abtastwertes oder der Abtastung relativ zum Signal nicht bekannt, da die, insbesondere zeitliche, Lage des Signals am Empfänger oder zweiten Objekt, insbesondere gemessen gegen eine absolute Zeit oder einen Taktgeber am zweiten Objekt, variieren kann und in der Regel nicht bekannt ist.

In bestehenden Datenübertragungssystemen findet in der Regel eine Anpassung von (relativen) Zeitmessungen im Sender und Empfänger statt, um klar zu erkennen, wann die Übertragung einer Informationseinheit, beispielsweise eines Symbols und/oder Chips beginnt und/oder endet. Die Systeme sind somit in der Regel Symbol synchronisiert. Daraus lassen sich Entfernungsmessungen ableiten, die aber nicht an die Möglichkeiten der erfindungsgemäßen Analyse heranreichen.

Im Bluetooth Standard wird dazu eine Uhr geführt und die weiteren Kommunikationspartner arbeiten mit einem offset zu dieser Uhr. Dazu führ jeder Kommunikationspartner eine eigene Uhr, die eine Zeitmessung (nicht Synchronisation) mit einer Genauigkeit von etwa 3*µ*s. Zur Synchronisierung wird beispielsweise der CSP Mechanismus verwendet. CSP bietet eine Genauigkeit der Synchronisierung von etwa 1 ms. Im allgemeinen erreichen bekannte Übertragungssystem eine Zeitsynchronisierung oder Signallaufzeitmessung mit einer Genauigkeit entsprechend der Symbolrate bis maximal zu einem Viertel der Symbolrate.

Insbesondere erreichen die erfindungsgemäßen Verfahren, Verwendungen und Systeme eine Genauigkeit der Analyse der, insbesondere zeitlichen, Lage, Laufzeitmessung besser als einem Viertel der Symbol- und/oder Chiprate und/oder besser als 0,25 ms beziehungsweise sind sie entsprechend eingerichtet.

Um im Stand der Technik eine zuverlässige Decodierung eines digitalen Datenstroms in einem analogen Signal zu gewährleisten muss das Sampling im Analog-Digital-Wandler mit einer Frequenz erfolgen, die deutlich höher liegt als die für die Datenübertragung notwendige Bandbreite der Frequenz des analogen Signals und/oder der Bandbreite der Frequenz des Signals, das, ggf. nach Filterung, dem Sampling im Analog-Digital-Wandler zugeführt wird. Dazu weisen Analog-Digital-Wandler meist vorgeschaltete, teilweise integrierte Filter auf. Dabei muss in der Regel die Abtast- oder Samplingrate oder -frequenz um mindestens etwa den Faktor zwei höher liegen als die für die Datenübertragung notwendige Bandbreite der Frequenz des analogen Signals und/oder der Bandbreite der Frequenz des Signals, das, ggf. nach Filterung, dem Sampling im Analog-Digital-Wandler zugeführt wird (Nyquist-Shannon-Abtasttheorem). Die Abtast- oder Samplingrate oder -frequenz liegt in der Regel auch mindestens beim doppelten der Chip- oder Symbolrate. Beispielsweise ist im Bluetooth Band bei 2450MHz mit einer durch Filterung (GFSK etc.) erreichten maximalen Ausgangsbandbreite am Sender von 2 MHz zu rechnen. Am Empfänger erfolgt in der Regel ein Sampling mit einer Abtastfrequenz von mindestens um 4 MHz.

Auf direktem Wege kann dann der Zeitpunkt einer Veränderung des empfangenen Signals (beispielsweise Veränderung von Amplitude und/oder Phase; insbesondere auf Grund einer Änderung des abgestrahlten Signals) bei einer Abtastfrequenz von 4 Mhz nur mit einer maximalen Auflösung von 4 MHz erfasst werden. In der Praxis wird aber intern in den verwendeten Chips bereits mit um einen einstelligen Faktor höheren Samplingraten gearbeitet, um eine möglichst robuste Übertragung zu gewährleisten.

Bei Bluetooth beispielsweise ist die Symbolrate 1MHz, die Sendefrequenz für logisch "1" liegt 500kHz oberhalb der Mittenfrequenz, für "0" liegt 500kHz unterhalb der Mittenfrequenz. Typischerweise wird mit der Mittenfrequenz gemischt, also bei logisch "1" mit Zwischenfrequenz plus 500KHz und bei logisch "0" mit Zwischenfrequenz minus 500kHz gearbeitet. Die Phase dreht dabei für eine logische "1" um XX° nach vorne und für logisch "0" XX° rückwärts.

Beim Senden wird die Frequenz aber in der Regel nicht stufenartig verstellt, da dies zu einer hohe Bandbreite oder Störungen in den Nebenkanälen führen würde, sondern meist mittels GFSK ein möglichst kontinuierlicher Übergang durchgeführt. Vorteilhafterweise wird zusätzlich der Signalverlauf meist im Empfänger hinter dem Mischer durch Filter vor der A/D Abtastung geglättet. Insbesondere einen solchen Signalverlauf macht sich die Erfindung zu nutze.

Ist der Verlauf des übertragenen, empfangenen oder abgestrahlten analogen Signals zumindest näherungsweise zumindest abschnittsweise bekannt, kann durch Auswertung dieses analogen Signalverlaufs, insbesondere einer Flanke des Signals, beispielsweise des Anstiegs der Amplitude, unter Ausnutzung der ohnehin erforderlichen und/oder verwendeten Samplingrate eine deutlich höhere Genauigkeit der Analyse der zeitlichen Lage des Signal oder der Flanke, der Phasenlage und/oder der Laufzeitmessung erreicht werden und dadurch auch eine deutlich genauere Synchronisierung, beispielsweise Zeitsynchronisierung, zwischen Sender und Empfänger und eine genauere Messung der Signallaufzeit erreicht werden und zwar um üblicherweise ohne Änderung der Hardware einen Faktor zwischen 2 und 16 genauer, was von der verwendeten Hardware abhängt, insbesondere vom Verhältnis der Bandbreite zur Samplingrate und der Auflösung (Bitttiefe) des Samplings.

Gelöst wird die Aufgabe durch ein Verfahren zur Analyse derzeitlichen Lage und/oder Phasenlage eines analogen Signals nach Anspruch 1, einem Verfahren zur Sicherung eines Zugangssystem nach Anspruch und einem Datenübertragungssystem nach Anspruch 12. Im Folgenden werden weitere Details der Erfindung beschrieben.

Das Verfahren zur Analyse der zeitlichen Lage und/oder Phasenlage ist insbesondere ein Verfahren zur Laufzeitmessung, Phasenmessung oder Synchronisierung. Dabei ist das Verfahren ein Verfahren in einemdigitalen Datenübertragungssystem, insbesondere einem Symbol- und/oder chipsynchronisiertem Übertragungssystem.

Dabei lassen sich die zeitliche Lage und Phasenlage eines Signals meist ineinander konvertieren oder in eine feste Beziehung setzten und sind aus der zeitlichen Lage oder Phasenlage in der Regel Laufzeitmessungen, Messungen der Phasenverschiebung oder eine Synchronisation möglich. Auch ist es meist möglichbei zumindest näherungsweiser Kenntnis des Signalverlaufs, insbesondere am ersten und/oder zweiten Objekt, beispielsweise durch Kenntnis des gesendeten Signalverlaufs, aus der zeitlichen Lage des empfangenen Signals die Phasenlage des empfangenen Signals näherungsweise zu bestimmen und umgekehrt. Generell kann mit dem Verfahren die, insbesondere zeitliche, Lage des analogen Signals oder die Phasenlage des analogen Signals oder beides gleichzeitig bestimmt werden, insbesondere relativ zu einer Referenzzeit, beispielsweise eines Zeitgebers, beispielsweise im zweiten Objekt.

Erfindungsgemäß wird die, insbesondere zeitliche, Lage des ersten oder zweiten analogen Signals am zweiten Objekt, insbesondere zu einer ersten Referenzzeit im und/oder am zweiten Objekt, bestimmt. Vorteilhafterweise wird in Abhängigkeit von der zeitlichen Lage des Signals am zweiten Objekt zu einer ersten Referenzzeit im und/oder am zweiten Objekt eine Aktion durchgeführt, insbesondere vom zweiten Objekt ein erstes Antwortsignal abgestrahlt wird, insbesondere derart, dass zwischen der zeitlichen Lage und/oder Phasenlage des ersten oder zweiten analogen Signals und des ersten Antwortsignals eine vorbestimmte und/oder kommunizierte Beziehung besteht.

Dabei werden die zeitliche Lage und/oder Phasenlage insbesondere gegen eine Referenzzeit und/oder einen Referenztakt gemessen, insbesondere am zweiten Objekt. Erfindungsgemäß wird mittels des Übertragungssystems mindestens eine erste digitale Information in mindestens einem ersten analogen Signal codiert von einem ersten zu einem zweiten Objekt und/oder zwischen zwei Objekten, insbesondere mittels mindestens eines ersten elektrischen, magnetischen oder elektromagnetischen Signals, insbesondere Welle, übertragen. Vorteilhafterweise beinhaltet die mindestens eine erste Information eine Vielzahl von Bits, Symbolen und/oder Chips und/oder ist die mindestens eine erste Information in einer Vielzahl von Bits, Symbolen und/oder Chips im Signal codiert.

Erfindungsgemäß wird mittels des Übertragungssystems mindestens eine erste Vielzahl von Symbolen und/oder Chips mit einer ersten Symbol- oder Chiprate in mindestens einem ersten analogen Signal (NF) codiert von einem ersten zu einem zweiten Objekt oder in mindestens einem zweiten analogen auf Basis des ersten analogen Signals erzeugten Signal (HF) von einem ersten zu einem zweiten Objekt, übertragen.

Bei der mindestens einen ersten Information, den Symbolen oder Chips kann es sich um beliebige handeln. Es können von diesem Verfahren und/oder der erfindungsgemäßen Analyse unabhängige Informationen, Symbole oder Chips übertragen werden, beispielsweise Nutzdaten und/oder zur Verbesserung des Verfahrens beispielsweise Informationen zum Signal oder deren Flanken.

Das Verfahren kann somit in herkömmlichen Übertragungssystemen angewandt werden und es können die ohnehin übermittelten Daten und Signale zur Durchführung der Analyse verwendet werden. Eine Übertragung von Daten eigens für die Analyse ist nicht zwingend notwendig, kann aber vorteilhaft sein. So können beispielsweise Informationen über das abgestrahlte Signal beinhaltet sein. Vorteilhafterweise wird insbesondere an und/oder in einem ersten der zwei Objekte zum Senden des mindestens einen ersten analogen Signals die mindestens eine erste Information in das mindestens eine erste analoge Signal mit einer ersten Frequenzbandbreite gewandelt, insbesondere mittels eines Modulation- und/oder Codierverfahren, wie QAM, FSK, insbesondere GFSK, und insbesondere mittels des mindestens einen ersten magnetischen, elektrischen oder elektromagnetischen Signals gesendet. Dabei kann das erste analoge Signale vor dem Senden weiter bearbeitet, insbesondere mit einer Trägerfrequenz gemischt und/oder gefiltert, werden. Das mindestens eine erste analoge Signal kann das mindestens eine erste magnetische, elektrische oder elektromagnetische Signal darstellen. Es ist zum Beispiel aber auch denkbar, dass das mindestens eine erste magnetische, elektrische oder elektromagnetische Signal durch Mischen des ersten analogen Signals mit einer Trägerfrequenz erzeugt wird.

Das mindestens eine erste Signal wird insbesondere vom ersten der zwei Objekte abgestrahlt.

Der Verlauf des Signals kann in der Regel aus Kenntnis der Parameter und Eigenschaften der Hardware des Senders oder Senders und Empfängers und der Kenntnis der übertragenden Information gewonnen werden und/oder gemessen und oder basierend auf Messungen berechnet werden. Je nach Ausgestaltung des Systems kann die Information des Signalverlaufs und/oder die zur Bestimmung dessen notwendigen Angaben über das gleiche Medium wie das Signal übertragen werden.

So ist der Verlauf der Flanke und das Vorkommen von Flanken allein schon aus den aus den übertragenen oder detektierten oder empfangenen Informationen unter Kenntnis des Übertragungssystems zumindest näherungsweise bestimmbar. Diese näherungsweise Kenntnis kann ausreichen. Sie kann aber durch weitere Maßnahmen verbessert werden, so können beispielsweise am Sender dort erzeugten und/oder abgestrahlten Signal gemessene Werte mit den Informationen übertragen und zur Verbesserung und/oder zur Gewinnung der Kenntnis über den zumindest näherungsweisen Verlauf der Flanke genutzt werden. Näherungsweise Kenntnis über den Verlauf des Signals am Empfänger kann also beispielsweise auch durch Kenntnis des Signalverlaufs am Sender, beim Abstrahlen und/oder in einer dem Abstrahlen vorgelagerten Stufe, beispielsweise vor einem Mischer oder vor einem Verstärker des Senders, gegeben sein.

Auch Kenntnisse über den Übertragungskanal und insbesondere Multipathingverhältnisse können zur Verbesserung und/oder zur Gewinnung der Kenntnis über den zumindest näherungsweisen Verlauf der Flanke genutzt werden. Optimal ist eine genaue Kenntnis. Diese ist aber in der Regel nicht gegeben. Das erfindungsgemäße Verfahren dient insbesondere nicht dazu, den Signalverlauf beispielsweise zur Nutzdatenextraktion rekonstruieren und auch nicht den Verlauf der Flanke ausmessen, sondern insbesondere zur möglichst genauen Bestimmung der zeitlichen Lage des Signals und/oder seiner Phasenlage, insbesondere relativ zu einer Referenzzeit, beispielsweise eines Zeitgebers im zweiten Objekt.

Als Signal kann dabei z.B. das Signal, das zur digitalen Datenübertragung verwendet wird, verwendet werden, aber auch ein anderes, das beispielsweise ausschließlich zu diesem Zweck verwendet wird und/oder z.B. die wiederholte und/oder andauernde Übertragung eines vorbestimmten und/oder konstanten logischen Signals, beispielsweise einer 0 oder einer 1, und/oder die wiederholte und/oder andauernde Übertragung des reinen Trägersignals, insbesondere für eine Zeitdauer zwischen 0,1 und 100ms, insbesondere für mindestens 2ms und/oder maximal 50ms, und/oder 10 bis 10000 Wiederholungen verwendet werden.

Angewendet werden kann dieses Verfahren in zahlreichen bekannten Übertragungssystemen wie Bluetooth, Wifi, DECT, Mobilfunk (GSM, UMTS, LTE, 5G), Ethernet und anderen. In vielen derartigen System ist die aktuell verbaute Hardware bereits in der Lage, die Erfindung umzusetzen. Mit Vorteil ist das erfindungsgemäße System somit ein Bluetooth, Wifi, DECT, Mobilfunk (GSM, UMTS, LTE, 5G) und/oder Ethernetsystem. Somit ist eine einfache und kostengünstige Implementation auch in bestehenden System meist möglich, meist durch Software und/oder Firmwareupdate.

Ist zudem der Signalverlauf oder Verlauf der Flanke einem potenziellen Angreifer nicht bekannt, lässt sich dadurch eine Zuverlässige Sicherung gegen Relaisangriffe erreichen, beispielsweise in Zugangskontrollsystemen, wie einem Auto mit Funkschlüssel.

Vorteilhafterweise wird und nach dem Empfang des mindestens einen ersten elektrischen, magnetischen oder elektromagnetischen Signals und/oder ersten analogen Signals an und/oder in einem zweiten der zwei Objekte eine Umwandlung des mindestens einen ersten elektrischen, magnetischen oder elektromagnetischen Signals und/oder ersten analogen Signals in empfangene erste digitale Information durchgeführt, die insbesondere möglichst der ersten digitalen Information entspricht und/oder wobei die Umwandlung insbesondere so erfolgt, dass die erste Information mit möglichst großer Wahrscheinlichkeit, mit großer Wahrscheinlichkeit und/oder bei Ausbleiben von Störungen wieder erhalten wird. Dies erfolgt insbesondere mittels mindestens eines ersten Analog-Digital-Wandlers, insbesondere an und/oder im zweiten Objekt, wobei mit dem mindestens einen ersten Analog-Digital-Wandler insbesondere eine Abtastung und/oder ein Sampling, insbesondere des mindestens einen ersten elektrischen, magnetischen oder elektromagnetischen Signals und/oder ersten analogen Signals, mit einer ersten Abtast- und/oder Samplingrate durchgeführt wird, wobei die erste Abtast- und/oder Samplingrate mindestens doppelt so groß und/oder schnell ist wie die erste Frequenzbandbreite, wie die Frequenzbandbreite des dem Analog-Digital-Wandler zugeführten Signals und/oder wie die Bandbreite, die zur Übertragung der mindestens einen ersten Information in der zur Übertragung der mindestens einen ersten Information verwendeten Zeit notwendig ist. Dem Abtasten und/oder Sampling kann eine Signalaufbereitung, beispielsweise Filterung oder Mischung vorausgehen.

Mit Vorteil ist die erste Frequenzbandbreite, die Frequenzbandbreite des dem Analog-Digital-Wandler zugeführten Signals und/oder der Bandbreite die zur Übertragung der mindestens einen ersten Information in der verwendeten Zeit der Übertragung der mindestens einen ersten Information notwendig ist und/oder verwendet wird 50 MHz oder weniger, insbesondere 16MHz oder weniger. Bei derartigen Bandbreiten ist die Genauigkeitsverbesserung und Angriffssicherheitsverbesserung gegen Relais-Angriffe durch das erfindungsgemäße Verfahren besonders ausgeprägt.

Mit Vorteil beträgt die Auflösung und/oder Bittiefe, also insbesondere die Feinheit der digitalen Umwandlung, der ersten Abtastung mehr als 1 Bit, insbesondere mehr als 6 Bit, bevorzugt mehr als 12 Bit. Dies erhöht die Genauigkeit des Verfahrens.

Erfindungsgemäß wird mindestens ein erster Abtastwert des mindestens einen ersten analogen Signals, gegebenenfalls nachdem das Signal weiterbearbeitet, insbesondere heruntergemischt und/oder gefiltert wurde, insbesondere mittels Tiefpass, verwendet, der insbesondere mittels des mindestens einen ersten Analog-Digital-Wandlers gewonnen wurde, um eine zeitlichen Lage und/oder Phasenlage zu bestimmen. Dabei liegt der mindestens eine erste Abtastwert in einer steigenden oder fallenden Flanke des mindestens einen ersten analogen Signals und/oder des mindestens einen ersten empfangenen analogen Signals, was beispielsweise aus dem Abtastwert selbst und/oder dem Verlauf benachbarter Abtastwerte erkannt werden kann.

Unter einem Abtastwert ist der Wert, beispielsweise der Amplitudenwert, einer Abtastung zu verstehen. Dabei findet die Abtastung zu einem Zeitpunkt oder (zum Beispiel zwecks Mittelung) über eine Zeitspanne statt. Das Ergebnis der Abtastung ist als ein Abtastwert zu einem Zeitpunkt oder einer Zeitspanne.

Unter Flanke ist insbesondere jede Veränderung des analogen Signals, beispielsweise in Bezug auf Amplitude, Frequenz, Phase, I und/oder Q Wert zu verstehen, die sich unter Annahme von mindestens zehn Zwischenwerten (die nicht alle abgetastet werden müssen), insbesondere kontinuierlich und/oder monoton, von einem ersten Wert zu einer ersten Zeit auf einen zweiten Wert zu einer zweiten Zeit ändert, wobei die Zwischenwerte zwischen dem ersten und dem zweiten Wert liegen und zwischen der ersten und der zweiten Zeit eingenommen werden und wobei insbesondere die Zwischenwerte im zeitlichen Verlauf von der ersten zu der zweiten Zeit monoton ansteigen oder monoton fallen, insbesondere streng monoton, insbesondere äquidistant in Bezug auf Wert und/oder Zeit verteilt sind, insbesondere bei Betrachtung des Signals ohne Multipatheffekte, Störungen und/oder Überlagerungen des Signals und/oder des Signals bei seiner Abstrahlung.

Erfindungsgemäß wird zusammen mit näherungsweiser Kenntnis über den Verlauf der Flanke im mindestens einen ersten analogen Signal am ersten Objekt, was insbesondere der Sender sein kann, die, insbesondere zeitliche, Lage des mindestens einen ersten Abtastwertes im mindestens einen ersten analogen Signal, insbesondere im und/oder am zweiten Objekt, und dadurch die zeitliche Lage und/oder Phasenlage des ersten analogen Signals zu einer ersten Referenzzeit, auch Referenztakt, insbesondere am und/oder im ersten und/oder zweiten Objekt, bestimmt. Vorteilhafterweise wird in Abhängigkeit von der zeitlichen Lage des Signals, insbesondere im und/oder am zweiten Objekt eine Aktion, insbesondere im und/oder am zweiten Objekt, durchgeführt, insbesondere wird vom zweiten Objekt ein erstes Antwortsignal abgestrahlt, insbesondere derart, dass zwischen der zeitlichen Lage und/oder Phasenlage des ersten analogen Signals, insbesondere im und/oder am zweiten Objekt, und des ersten Antwortsignals, insbesondere im und/oder am zweiten Objekt, insbesondere einer Flanke des ersten Antwortsignals und/oder zwischen dem Empfang und/oder dem Abtasten des mindestens einen ersten Signals, insbesondere der Flanke des mindestens einen ersten analogen Signals, insbesondere im und/oder am zweiten Objekt, und dem Abstrahlen des ersten Antwortsignals, insbesondere einer Flanke des ersten Antwortsignals, eine, insbesondere vorbestimmte Beziehung besteht und/oder diese Beziehung an das erste Objekt und/oder eine Auswerteeinheit übertragen wird.

Insbesondere sind das erste und das zweite Objekt voneinander beabstandet und/oder relativ zueinander beweglich. Insbesondere wird das erste analoge Signal mittels Funk und/oder Kabel vom ersten an das zweite Objekt übertragen.

Vorteilhafterweise handelt es sich um ein bidirektionales, digitales, Datenübertragungssystem, wobei nicht unbedingt Nutzdaten bidirektional übertragen werden müssen, eine Übertragung von Nutzdaten in eine Richtung und Übertragung zum Beispiel von Quittierungsdaten in die andere reicht aus.

Insbesondere wird mittels des Übertragungssystems mindestens eine zweite digitale, Information in mindestens einem zweiten analogen Signal codiert vom zweiten zum ersten Objekt, insbesondere mittels mindestens einem zweiten elektrischen, magnetischen oder elektromagnetischen Signal übertragen. Dabei wird insbesondere am und/oder im zweiten Objekt zum Senden des mindestens einen zweiten elektrischen, magnetischen oder elektromagnetischen Signal die zweiten Informationen in das mindestens eine erste analoge Signal mit einer zweiten Frequenzbandbreite gewandelt, insbesondere mittels eines Modulation- und/oder Codierverfahren, wie QAM, FSK, insbesondere GFSK, und insbesondere mittels der mindestens einen zweiten elektromagnetischen Signal gesendet. Dabei kann das zweite analoge Signale vor dem Senden weiter bearbeitet, insbesondere mit einer Trägerfrequenz gemischt und/oder gefiltert, werden. Das mindestens eine zweite analoge Signal kann das mindestens eine zweite magnetische, elektrische oder elektromagnetische Signal darstellen. Es ist zum Beispiel aber auch denkbar, dass das mindestens eine zweite magnetische, elektrische oder elektromagnetische Signal durch Mischen des zweiten analogen Signals mit einer Trägerfrequenz erzeugt wird.

Insbesondere wird nach dem Empfang des mindestens einen zweiten elektrischen, magnetischen oder elektromagnetischen Signal und/oder des zweiten analogen Signal, insbesondere am und/oder im ersten Objekt, eine Umwandlung des mindestens einen zweiten magnetischen, elektrischen oder elektromagnetischen Signals und/oder des zweiten analogen Signals in empfangene zweite digitale Information, insbesondere mittels mindestens eines zweiten Analog-Digital-Wandler, insbesondere am und/oder im ersten Objekt, durchgeführt.

Insbesondere wird, insbesondere mit dem mindestens einen zweiten Analog-Digital-Wandler, mindestens eine erste Abtastung und/oder ein Sampling, insbesondere des zweiten analogen Signals und/oder des mindestens einen zweiten magnetischen, elektrischen oder elektromagnetischen Signals, (auch eine mindestens eine zweite Abtastung genannt), insbesondere im und/oder am ersten Objekt, mit einer zweiten Abtast- und/oder Samplingrate durchgeführt. Insbesondere ist die zweite Abtast- und/oder Samplingrate mindestens doppelt so groß und/oder schnell wie die zweite Frequenzbandbreite, wie die Frequenzbandbreite des dem zweiten Analog-Digital-Wandler zugeführten Signal und/oder wie die Bandbreite, die zur Übertragung der mindestens einen zweiten Information in der zur Übertragung der mindestens einen zweiten Information verwendeten Zeit notwendig ist.

Mit Vorteil ist die zweite Frequenzbandbreite, die Frequenzbandbreite des dem zweiten Analog-Digital-Wandler zugeführten Signals und/oder die Bandbreite die zur Übertragung der mindestens einen zweiten Information in der verwendeten Zeit der Übertragung der mindestens einen zweiten Information notwendig ist und/oder verwendet wird, und/oder insbesondere 50 MHz oder weniger, insbesondere 16MHz oder weniger. Bei derartigen Bandbreiten ist die Genauigkeitsverbesserung und Angriffssicherheitsverbesserung gegen Relais-Angriffe durch das erfindungsgemäße Verfahren besonders ausgeprägt.

Mit Vorteil beträgt die Auflösung und/oder Bittiefe, also insbesondere die Feinheit der digitalen Umwandlung, der ersten Abtastung des zweiten Signals mehr als 1 Bit, insbesondere mehr als 6 Bit, bevorzug mehr als 12 Bit. Dies erhöht die Genauigkeit des Verfahrens.

Vorteilhafterweise wird der mindestens eine erste Abtastwert des mindestens einen zweiten analogen Signals, der auch als mindestens ein zweiter Abtastwert bezeichnet werden kann und insbesondere ein Abtastwert des zweiten Analog-Digital-Wandlers ist, verwendet, um eine zeitlichen Lage und/oder Phasenlage zu bestimmen. Dabei kann der mindestens eine zweite Abtastwert auch ermittelt werden, nachdem das Signal weiterbearbeitet, insbesondere heruntergemischt und/oder gefiltert wurde, insbesondere mittels Tiefpass.

Dabei liegt der mindestens eine zweite Abtastwert in einer steigenden oder fallenden Flanke des mindestens einen zweiten analogen Signals und/oder zweiten empfangenen analogen Signals, was beispielsweise aus dem Abtastwert selbst und oder dem Verlauf benachbarter Abtastwerte erkannt werden kann.

Vorteilhafterweise wird zusammen mit Kenntnis über den Verlauf der Flanke im mindestens einen zweiten analogen Signals die, insbesondere zeitliche, Lage und/oder Phasenlage des zweiten analogen Signals zu einer zweiten Referenzzeit, auch zweiter Referenztakt, insbesondere am und/oder im ersten Objekt, bestimmt und/oder wird in Abhängigkeit von der zeitlichen Lage des Signals, insbesondere im und/oder am ersten Objekt eine Aktion, insbesondere im und/oder am ersten Objekt, durchgeführt, insbesondere wird vom ersten Objekt ein zweites Antwortsignal abgestrahlt, insbesondere derart, dass zwischen der zeitlichen Lage und/oder Phasenlage des zweiten analogen Signals, insbesondere im und/oder am ersten Objekt, und des zweiten Antwortsignals, insbesondere im und/oder am ersten Objekt, und/oder zwischen dem Empfang und/oder dem Abtasten des mindestens einen zweiten Signals, insbesondere im und/oder am ersten Objekt, und dem Abstrahlen des zweiten Antwortsignals eine, insbesondere vorbestimmte, Beziehung besteht und/oder diese Beziehung an das zweite Objekt und/oder die Auswerteeinheit übertragen wird.

Mit besonderem Vorteil stellt das erste Antwortsignal mindestens ein zweites analoges Signal dar und/oder enthält das erste Antwortsignal mindestens ein zweites analoges Signal. Mit besonderem Vorteil stellt das zweite Antwortsignal mindestens ein erstes analoges Signal dar und/oder enthält das zweite Antwortsignal mindestens ein erstes analoges Signal.

Mit Vorteil wird das Verfahren mehrfach wiederholt und insbesondere eine Mittelung der zeitlichen Lagen, Laufzeiten und/oder Phasenverschiebungen der einzelnen Wiederholungen vorgenommen. Dabei kann insbesondere jede Flanke eines analogen Signals zur Durchführung des Verfahrens verwendet werden, solche Flanken sind bei analogen Signale, in denen digitale Informationen codiert sind, zahlreich vorhanden. Mit Vorteil wird das Verfahren wiederholt unter Verwendung unterschiedlicher Antennen am ersten und/oder zweiten Objekt durchgeführt und/oder zeitgleich mehrfach unter Verwendung mehrerer, insbesondere unterschiedlicher Antennen am ersten und/oder zweiten Objekt durchgeführt und/oder werden zur Abstrahlung und/oder zum Empfang des mindestens einen ersten und/oder mindestens einen zweiten analogen Signal und/oder des mindestens einen ersten und/oder mindestens einen zweiten magnetischen, elektrischen oder elektromagnetischen Signal am ersten und/oder zweiten Objekt mehrere, insbesondere unterschiedliche, Antennen verwendet. Bei Verwendung mehrerer Antennen werden diese bevorzugt so verwendet, dass ihre Polarisationsrichtungen unterschiedlich sind, insbesondere senkrecht zueinander stehen.

Mit besonderem Vorteil wird das Verfahren bei einer Übertragung mittels I&Q-Verfahren und/oder QAM mindestens zweifach, insbesondere parallel unter Verwendung mindestens einer Flanke des I Signals oder Signalanteils als erstes und/oder zweites analoges Signal und unter Verwendung mindestens einer Flanke des Q Signals oder Signalanteils als erstes und/oder zweites analoges Signal durchgeführt.

Vorteilhafterweise wird eine erste Signallaufzeit und/oder erste Phasenverschiebung des mindestens einen ersten analogen Signals vom ersten zum zweiten Objekt und/oder eine zweite Signallaufzeit und/oder zweite Phasenverschiebung des mindestens einen zweiten analogen Signals vom zweiten zum ersten Objekt und/oder eine Rundlaufsignallaufzeit und/oder Rundlaufphasenverschiebung des mindestens einen ersten analogen Signals und des mindestens einen zweiten analogen Signals vom ersten Objekt über das zweiten Objekt zum ersten Objekt bestimmt.

Dies kann beispielsweise dadurch erfolgen, dass das erste analoge Signal eine Flanke, beginnend zu einer ersten Zeit, aufweisend am ersten Objekt gesendet wird und das zweite Objekt die Zeit des Empfangs mindestens eines ersten Abtastwertes in der Flanke des empfangenen ersten analogen Signal relativ zu einem Referenztakt bestimmt und ein erstes Antwortsignal abstrahlt, das ein zweites analoges Signal mit einer Flanke, beginnend zu einer zweiten Zeit, beinhaltet oder darstellt und das zweite Objekt die mindestens eine zwischen Empfang des mindestens einen ersten Abtastwertes der Flanke des ersten analogen Signals und Abstrahlen des Begins der Flanke des zweiten analogen Signals vergangene erste Zeitspanne an das erste Objekt und/oder eine Auswerteinrichtung überträgt. Das erste und/oder zweite Objekt und/oder die Auswerteinrichtung bestimmt zudem die mindestens eine zwischen Abstrahlen des dem mindestens einen ersten Abtastwert entsprechenden Wertes der Flanke des ersten analogen Signals und Empfang mindestens eines zweiten Abtastwertes in der Flanke des zweiten analogen Signals vergangene zweite Zeitspanne. Das erste und/oder zweite Objekt und/oder die Auswerteinrichtung bestimmt darüber hinaus die mindestens eine zwischen Abstrahlung des Begins der Flanke des zweiten analogen Signals und Abstrahlung mindestens eines dem mindestens einen zweiten Abtastwert entsprechenden Wertes in der Flanke des zweiten analogen Signals vergangene dritte Zeitspanne. Aus den Zeitspannen lässt sich die Rundlaufzeit und somit die Entfernung bestimmen, indem die Rundlaufzeit als zweite Zeitspanne minus erster Zeitspanne und minus dritter Zeitspanne angenommen wird. Dabei ist jedem Paar von erstem Abtastwert des ersten Signals und erstem Abtastwert des zweiten Signals eine erste, eine zweite und eine dritte Zeitspanne zugeordnet. Über die sich aus verschiedenen ersten, zweiten und dritten Zeitspannen ergebenen Rundlaufzeiten kann gemittelt werden.

Vorteilhafterweise wird aus der ersten und/oder zweiten Signallaufzeit und/oder ersten und/oder zweiten Phasenverschiebung und/oder Rundlaufsignallaufzeit und/oder Rundlaufphasenverschiebung eine Entfernung zwischen dem ersten und zweiten Objekt bestimmt.

Vorteilhafterweise wird der Signalverlauf, insbesondere die Anordnung und/oder die Ausgestaltung und/oder der Verlauf der Flanken, des mindestens einen ersten und/oder zweiten analogen Signals vom ersten zum zweiten Objekt und/oder umgekehrt und/oder an eine Auswerteinrichtung kommuniziert, insbesondere verschlüsselt. Vorteilhafterweise wird die, insbesondere zeitliche, Lage und/oder Phasenlage des zweiten analogen Signals und/oder mindestens eines zweiten Abtastwertes und insbesondere der mindestens eine zweite Abtastwert in einer Flanke des zweiten Signals am ersten Objekt, vom ersten und zum zweiten Objekt und/oder an die Auswerteinrichtung kommuniziert.

Vorteilhafterweise wird die, insbesondere zeitliche, Lage und/oder Phasenlage des ersten analogen Signals und/oder dessen Flanke am zweiten Objekt und/oder mindestens eines ersten Abtastwertes und insbesondere der mindestens eine erste Abtastwert in einer Flanke des ersten Signals, vom zweiten zum ersten Objekt und/oder an die Auswerteinrichtung kommuniziert.

Vorteilhafterweise wird der Zeitpunkt des Abstrahlens des ersten und/oder zweiten Signals und/oder mindestens einer Flanke des ersten und/oder zweiten Signals an das erste oder zweite Objekt und/oder die Auswerteeinrichtung kommuniziert.

In Multipathumgebungen werden Flanken eines ersten oder zweiten Signals bei der Übertragung und/oder sind sie beim Empfang am Empfänger durch Überlagerungen verschiedener Übertragungswege verändert, beispielsweise verschlissen.

In solchen Fällen ist es teilweise nicht mehr möglich einen einzelnen Abtastwert des empfangenen Signals einem Punkt im abgestrahlten Signal zuzuordnen. Meist ist es dann erst durch die Nahme zahlreicher Messerte und deren Verarbeitung möglich, eine Zuordnung herzustellen und/oder die Flanke des Signalanteils eines oder weniger Ausbreitungswege zu ermitteln. Auch ist es meist nicht oder nur mit unzumutbarem Aufwand möglich, die Form der Flanke am Empfänger aus dem abgestrahlten Signal zu errechnen. Insbesondere in solchen Fällen beinhaltet das Verfahren insbesondere das Senden eines ersten Testsignals mit mindestens einer Testflanke vom ersten zum zweiten Objekt und/oder das Senden eines zweiten Testsignals mit mindestens einer Testflanke vom zweiten zum ersten Objekt und das Vermessen zumindest eines Abschnitts der Testflanke des ersten Signals am zweiten Objekt und/oder des zweiten Testsignals am ersten Objekt und, insbesondere mehrfache, Durchführung des Verfahrens mit einem ersten und/oder zweiten Signal, wobei die Testflanke ähnlich zur oder identisch zur Flanke im ersten und/oder zweiten Signal ist, insbesondere das erste und/oder zweite Signal ähnlich zum oder identisch zum Testsignal ist.

Mit besonderem Vorteil sind/werden örtlich fix mit dem zweiten Objekt verbunden aber von diesem beabstandet, insbesondere um mindestens 10 cm beabstandet, mehrere zweite Empfangsvorrichtungen zum Empfang des mindestens einen ersten analogen Signals vorgesehen und/oder wird bezüglich jeder der mehreren zweiten Empfangsvorrichtungen mindestens eine zeitliche Lage und/oder Phasenlage bestimmt. Insbesondere ist das zweite Objekt und sind die mehreren zweiten Empfangsvorrichtungen Teil eines Kraftfahrzeuges und/oder das erste Objekt ein Zugangsmittel, insbesondere ein drahtloser Schlüssel. Insbesondere ist das zweite Objekt und sind die mehreren zweiten Empfangsvorrichtungen Teil eines Zugangsmittel, insbesondere eines drahtlosen Schlüssels, und/oder ist das erste Objekt ein Kraftfahrzeug. Insbesondere wird auf Basis der am zweiten Objekt und/oder den mehreren zweiten Empfangsvorrichtungen empfangenen ersten Signals, insbesondere des ersten Abtastwertes des mindestens einen ersten Signals, eine Richtung und/oder eine Entfernung bestimmt, in der das erste Objekt liegt, insbesondere durch Triangulation, insbesondere durch eine Auswerteeinheit. Insbesondere wird auf Basis des am zweiten Objekt und/oder den mehreren zweiten Empfangsvorrichtungen empfangenen mindestens einen ersten Signals ein Winkel und/oder eine Winkeldifferenz zwischen erstem und zweitem Objekt und/oder einer der mehreren zweiten Empfangsvorrichtungen und/oder zwischen zweitem Objekt und einer der mehreren zweiten Empfangsvorrichtungen, insbesondere durch Phasenvergleich des mindestens einen ersten Signals, insbesondere des ersten Abtastwertes des mindestens einen ersten Signals, am zweiten Objekt und/oder den mehreren zweiten Empfangsvorrichtungen, insbesondere durch eine Auswerteeinheit. Insbesondere wird dadurch eine relative Orientierung, ein Winkel, eine Änderung der relativen Orientierung und/oder des Winkels, eine Entfernung und/oder Änderung der Entfernung zwischen mindestens einem ersten und einem zweiten Objekt und/oder einer zweiten Empfangsvorrichtung bestimmt, insbesondere durch eine Auswerteeinheit.

Mit besonderem Vorteil sind/werden örtlich fix mit dem ersten Objekt verbunden aber von diesem beabstandet, insbesondere um mindestens 10 cm beabstandet, mehrere erste Objekte vorgesehen und/oder wird bezüglich jedes der mehreren ersten Objekten das Verfahren durchgeführt und wird insbesondere aus den am zweiten Objekt empfangenen mindestens einen Signal, insbesondere ersten Abtastwert des mindestens einen ersten Signals, bezüglich jedes ersten Objekts mindestens eine zeitliche Lage und/oder Phasenlage bestimmt.

Mit besonderem Vorteil wird auf Grund der Phasenänderung zwischen dem mindestens einem ersten empfangenen Signal und mindestens einem weiteren ersten Signal eine Entfernungsänderung zwischen erstem und zweitem Objekt bestimmt und/oder wird daraus bestimmt, um welche Länge sich mindestens zwei Signalwege des ersten und der ersten weiteren Signal unterscheiden, insbesondere unter Annahme einer statischen Anordnung und Umgebung des ersten und zweiten Objekts während der Übertragung des ersten und der ersten weiteren Signale, insbesondere durch eine Auswerteeinheit. Insbesondere wird der kürzeste Signalweg und/oder der Signalanteil bestimmt, der über den kürzesten Signalweg empfangen wurde, insbesondere durch eine Auswerteeinheit.

Mit besonderen Vorteil wird aufgrund der Phasenänderung zwischen dem empfangenen ersten Signal und dem mindestens einen ersten weiteren Signalen ein Einstrahlwinkel und/oder eine Änderung dessen zwischen ersten und zweiten Objekt bestimmt und/oder wird daraus bestimmt, um welchen Einstrahl- und/oder Abstrahlwinkel sich mindestens zwei Signalwege des ersten und der ersten weiteren Signale unterscheiden, insbesondere unter der Annahme einer statischen Anordnung und Umgebung des ersten und zweiten Objekts und/oder der Empfangsvorrichtungen und des zweiten Objekts während der Übertragung des ersten und der ersten weiteren Signale, insbesondere durch eine Auswerteeinheit. Gelöst wird die Aufgabe auch durch ein Verfahren nach Anspruch 11, also einem Verfahren zur Sicherung eines Zugangssystems aufweisend ein erstes Objekt, insbesondere Autorisierungsmittel, und ein zweites Objekt, insbesondere Zugangskontrollmittel, wobei zwischen dem ersten Objekt und dem zweiten Objekt elektrisch, magnetisch oder elektromagnetisch mindestens eine erstes analoges Signal codiert von dm ersten Objekt zu dem zweiten Objekt mittels eines Übertragungssystems übertragen wird, wobei eine zeitliche Lage und/oder Phasenlage mittels einem erfindungsgemäßen Verfahrens oder Systems bestimmt wird und bei Überschreiten einer vorbestimmten Abweichung der bestimmten zeitlichen Lage und/oder Phasenlage von der ersten Referenzzeit und/oder bei Abweichung der der bestimmten zeitlichen Lage und/oder Phasenlage von einem vorbestimmten oder mit anderen Methoden berechneten der zeitlichen Lage und/oder Phasenlage der Zugang, Zutritt, das Aktivieren, das Deaktivieren und/oder ein Öffnen durch das zweite Objekt, insbesondere Zugangskontrollmittel, verwehrt wird und/oder auf Basis der der bestimmten zeitlichen Lage und/oder Phasenlage eine Signallaufzeit und/oder Signalrundlaufzeit und/oder eine Entfernung bestimmt wird und wenn die bestimmte Signallaufzeit und/oder Signalrundlaufzeit und/oder Entfernung eine vorbestimmte Signallaufzeit und/oder Signalrundlaufzeit und/oder eine vorbestimmte Entfernung und/oder eine vorbestimmte Abweichung von auf anderem Weg oder mittels anderem Verfahren bestimmte Signallaufzeit und/oder Signalrundlaufzeit und/oder Entfernung überschreitet, der Zugang, Zutritt, das Aktivieren, das Deaktivieren und/oder das Öffnen, insbesondere durch das zweite Objekt, insbesondere Zugangskontrollmittel, verwehrt wird.

Mit der Erfindung ist auch eine Umsetzung als ein Zugangskontrollsystem aufweisend ein erstes Objekt, insbesondere ein Autorisierungsmittel, und ein zweites Objekt, insbesondere ein Zugangskontrollmittel, vorstellbar, wobei das Zugangskontrollsystem ein Übertragungssystem, insbesondere eine erste und zweite Antenne aufweisend, aufweist, eingerichtet zwischen dem ersten Objekt und dem zweiten Objekt mindestens einem erstes analoges Signal codiert von dem ersten Objekt zu dem zweiten Objekt zu übertragen, wobei das Zugangskontrollsystem eingerichtet ist, eine zeitliche Lage und/oder Phasenlage mittels einem der vorstehenden Verfahren zu bestimmen und bei Überschreiten einer vorbestimmten Abweichung der zeitlichen Lage und/oder Phasenlage von der ersten Referenzzeit und/oder bei Abweichung der zeitlichen Lage und/oder Phasenlage von einer vorbestimmten oder mit anderen Methoden berechneten zeitlichen Lage und/oder Phasenlage den Zugang, Zutritt, das Aktivieren, das Deaktivieren und/oder das Öffnen, insbesondere durch das zweite Objekt, insbesondere Zugangskontrollmittel, zu verwehren
und/oder auf Basis der bestimmten zeitlichen Lage und/oder Phasenlage eine Signallaufzeit und/oder Signalrundlaufzeit und/oder eine Entfernung zu bestimmen und bei Überschreiten einer vorbestimmten Signallaufzeit und/oder Signalrundlaufzeit und/oder einer vorbestimmten Entfernung und/oder bei Überschreiten einer vorbestimmten Abweichung von auf anderem Weg oder mittels anderem Verfahren oder anderen Mitteln bestimmter Signallaufzeit und/oder Signalrundlaufzeit und/oder Entfernung einen Zugang, einen Zutritt, eine Aktivieren, Deaktivieren und/oder ein Öffnen, insbesondere des Zugangskontrollmittels und/oder durch das Zugangskontrollmittel, zu verwehren.

Gelöst wird die Aufgabe auch durch ein digitales Übertragungssystem nach Anspruch 12, nämlich ein Übertragungssystem, insbesondere Symbol synchronisiertes Übertragungssystem, mit Mitteln zur Analyse der zeitlichen Lage und/oder Phasenlage mindestens eines ersten oder zweiten analogen Signals, insbesondere zur Laufzeitmessung, Phasenmessung oder Synchronisierung, wobei das Übertragungssystem mindestens zwei Objekte aufweist und eingerichtet ist, mindestens eine erste Information in mindestens einem ersten analogen Signal codiert oder in mindestens einem zweiten analogen auf Basis des ersten analogen Signals erzeugten Signal (HF) zwischen den zwei Objekten zu übertragen,
dadurch gekennzeichnet, dass das System eingerichtet ist, mindestens einen ersten Abtastwert des mindestens einen ersten oder zweiten analogen Signals nach der Übertragung zwischen den zwei Objekten in einer steigenden oder fallenden Flanke des mindestens einen ersten analogen Signals zu nehmen und diesen zu verwenden, um eine zeitlichen Lage und/oder Phasenlage des mindesten einen ersten oder zweiten analogen Signals dadurch zu bestimmen, dass aus dem mindestens einen ersten Abtastwert, insbesondere zusammen mit zumindest näherungsweiser Kenntnis über den Verlauf der Flanke im mindestens einen ersten oder zweiten analogen Signal, insbesondere am ersten und/oder zweiten Objekt, die, insbesondere zeitliche, Lage des mindestens einen ersten Abtastwertes im mindestens einen ersten analogen Signal am zweiten Objekt und dadurch die, insbesondere zeitliche, Lage des ersten analogen Signals, insbesondere zu einer Referenzzeit im zweiten Objekt zu bestimmen. Vorteilhafterweise wird in Abhängigkeit von der, insbesondere zeitlichen, Lage des ersten oder zweiten Signals eine Aktion durchgeführt, insbesondere vom zweiten Objekt ein erstes Antwortsignal abgestrahlt, insbesondere derart, dass zwischen der, insbesondere zeitlichen, Lage des ersten oder zweiten analogen Signals und des ersten Antwortsignals eine vorbestimmte und/oder im Übertragungssystem kommunizierte Beziehung besteht.

Gelöst wird die Aufgabe auch durch die Verwendung nach Anspruch 13, also einer Verwendung einer zeitlichen Lage und/oder Phasenlage zur Zutrittskontrolle, Authentifizierung, Entfernungsmessung, Synchronisierung und/oder zur Erkennung und/oder zur Abwehr von Relayangriffen, wobei mittels eines Übertragungssystems, insbesondere eine ersten und zweite Antenne aufweisend, mindestens ein erstes analoges Signal codiert von einem ersten zu einem zweiten Objekt übertragen und verwendet wird, um die zeitliche Lage und/oder Phasenlage zu detektieren, wobei die zeitliche Lage und/oder Phasenlage mittels eines der vorgenannten Verfahren und/oder Systems bestimmt wird.

Insbesondere wird bezüglich der Verfahren, der Verwendung und/oder Systems ein Zugang, ein Zutritt, ein Aktivieren, ein Deaktivieren und/oder ein Öffnen, insbesondere durch das Zugangskontrollmittel und/oder des Zugangskontrollmittels, gewährt, wenn keine Abweichung und/oder Überschreitung vorliegt oder wenn keine Abweichung und/oder Überschreitung vorliegt. Insbesondere der Zugang, der Zutritt, das Aktivieren, Deaktivieren und/oder das Öffnen nur gewährt, wenn bei einer Vielzahl von Wiederholungen keine oder nur einer vorbestimmte Anzahl von Abweichung(en) und/oder Überschreitung(en) vorliegt/en oder wenn keine oder maximal eine vorbestimmte Anzahl von Abweichung(en) und/oder Überschreitung(en) vorliegt/en.

Insbesondere wird der Zugang, der Zutritt, das Aktivieren, Deaktivieren und/oder das Öffnen nur gewährt, wenn mindestens eine weitere Authentifizierungsanforderung erfüllt ist, beispielsweise ein korrektes Passwort eingegeben wird oder das Zertifikat gültig und/oder im Zugangssystem als zulässig gekennzeichnet ist. Mit besonderem Vorteil beinhaltet die mindestens eine Authentifizierungsanforderung eine Vielzahl von Authentifizierungsanforderung, die von dem Zeitpunkt des Empfangs abhängen, insbesondere nach dieser Anmeldung und/oder mindestens eine Authentifizierungsanforderung, die unabhängig von dem Empfangszeitpunkt ist. Unabhängig vom Empfangszeitpunkt ist auch die zeitliche Gültigkeit eines Zertifikates, die zwar von der Zeit abhängen mag, aber nicht unmittelbar von der Zeit des Empfangs selbst.

Als Zugang wird insbesondere nicht nur ein Zugang in einen Bereich, im Sinne der möglich Bewegung eines Gegenstandes und/oder einer Person in diesen Bereich, beispielsweise das innere eines Raumes oder eines Fahrzeuges, sondern insbesondere auch der Zugang zu einer Funktion, insbesondere auch im Sinne von Aktivierung einer Funktion, verstanden, so beispielsweise der Zugang zu der Funktion des Anlassens oder Startens einer Fahrzeuges oder der Zugang zu der Funktion "Kaffee ausgeben" einer Kaffeemaschine. Entsprechend sind Zugangskontrollsysteme insbesondere nicht nur solche, die nur einen Zugang in einen Bereich, im Sinne der möglich Bewegung eines Gegenstandes und/oder einer Person in diesen Bereich hinein, kontrollieren, beschränken und/oder schützen, sondern insbesondere auch solche, die den Zugang zu einer Funktion, insbesondere auch im Sinne von Aktivierung einer Funktion, kontrollieren, beschränken und/oder schützen.

Als Zugangskontrollsystem kommen insbesondere Autorisierungssystem, beispielsweise zur Anmeldung in einem Computersystem, beispielsweise mittels Passwort und/oder Zertifikat, oder auch klassische Zugangskontrollsysteme wie Schlösser, Schranken, Türen und/oder Schleusen und/oder Aktivierung von Funktionen, beispielsweise einer Servicestation, wie Kaffeeautomat, in Frage. Insbesondere kann es sich dabei um Türen und/oder Zündschlösser und/oder Anlasser eines Fahrzeuges (z.B. Kraftfahrzeug, Flugzeug, Schiff oder autonomes Taxi - sowie aller denkbaren weiteren) handeln. Ebenfalls kann es sich um einen Zugang zu einer und/oder Aktivierung einer beliebigen Servicestation (Geldautomat, Telefon, Kaffeeautomat - die Liste ist beliebig erweiterbar) handeln. Als Autorisierungsmittel kommen beispielsweise Mobiltelefon, Schlüssel, Zertifikate und/oder Eingabesysteme zur Eingabe von Passwörtern in Frage.

Insbesondere handelt es sich bei dem Übertragungssystem der Verfahren, der Verwendung und/oder des Systems um ein drahtloses, beispielsweise eines verwendet für die Kommunikation mit Funkschlüsseln oder Nahfeldschlüsseln, insbesondere für Kraftfahrzeuge, und/oder zwischen einem solchen und einem Kraftfahrzeug oder um zwei Bluetoothmodule.Insbesondere beinhaltet das Verfahren das mehrfache Senden eines ersten Testsignals mit mindestens einer Testflanke vom ersten zum zweiten Objekt und/oder das mehrfache Senden eines zweiten Testsignals mit mindestens einer Testflanke vom zweiten zum ersten Objekt und das Vermessen zumindest eines Abschnitts der Testflanke des ersten Testsignals am zweiten Objekt und/oder des zweiten Testsignals am ersten Objekt durch zwischen den Wiederholungen zeitlich versetztes Sampling des empfangenen Testsignals und rekonstruieren der empfangenen Testflanke aus den zeitlich versetzten Samplings der Testflanken des mehrfachen Sendens bzw. deren Empfang, dies unter der Annahme, dass die Änderung der Umgebungseinflüsse über die Dauer der Wiederholungen zu vernachlässigen ist und insbesondere die Testflanken der mehrfachen Übertragung identisch empfangen werden. Insbesondere ist das mehrfache Senden ein mindestens 5-faches, insbesondere mindestens 10-faches, Senden. Insbesondere findet das mehrfache Senden in einer Zeitspanne von weniger als 10s, insbesondere weniger als 1s, insbesondere weniger als 500ms statt.

Auch kann meist angenommen werden, dass der Einfluss der Umgebung unabhängig von der Richtung der Übertragung zwischen erstem und zweitem Objekt ist und somit das Vermessen und/oder die Kenntnis über die Veränderung der durch die Übertragung in eine Richtung und/oder das Vermessen und/oder die Kenntnis der am ersten oder zweiten Objekt empfangenen Flanke und/oder Testflanke ausreicht.

So kann eine Wiederholung der Abstrahlung mit einer Wiederholfrequenz FW erfolgen und kann das Sampling mit einer Frequenz FS erfolgen, wobei zwischen den einzelnen Wiederholungen des Sendens oder des Empfangs der Wiederholungen des Sendens, das Sampling des empfangenen Signals zeitlich so verändert wird, dass die zeitliche Lage der Samplings relativ zum abgestrahlten Signal um einen zeitliche Betrag kleiner der Zeit zwischen zwei Samplings verschoben wird und insbesondere mindestens fünf, insbesondere mindestens 10, Samplings an unterschiedlichen zeitlichen Positionen in den Wiederholungen der Testflanke, und/oder der Signal- oder Chipperiode genommen werden.

Insbesondere stellt das Testsignal oder beinhaltet das Testsignal ein erstes oder zweites Signal, insbesondere einer vorausgehenden oder nachfolgenden Durchführung des Verfahrens und/oder eines vorausgehendes oder nachfolgenden ersten oder zweitens Signals der Durchführung des Verfahrens dar. Das Testsignal kann auch das erste Signal oder das zweite Signal der Durchführung des Verfahrens darstellen oder beinhalten, bei der die aus dem Testsignal gewonnene Kenntnis über die Flanke verwendet wird.

Insbesondere wird das Verfahren so durchgeführt, dass angenommen wird, dass die Veränderung bei der Übertragung des ersten oder zweiten Testsignals identisch oder näherungsweise identisch zu der Veränderung bei der Übertragung der weiteren ersten oder zweiten Testsignale und/oder zu der Veränderung bei der Übertragung des zweiten Signals vom zweiten zum ersten Objekt ist, insbesondere wenn die Flanke im ersten Signal mit der im zweiten Signal identisch und/oder näherungsweise identisch ist und/oder dass angenommen wird, dass die Veränderung bei der Übertragung eines ersten Signals einer ersten Ausführung der Schritte vom ersten zum zweiten Objekt identisch oder näherungsweise identisch zu der Veränderung bei der Übertragung eines zweiten ersten Signals vom zweiten zum ersten Objekt ist, insbesondere wenn die Flanke im ersten Signal mit der im zweiten Signal identisch und/oder näherungsweise identisch ist.

Bevorzugt werden erste und zweite Objekte und/oder die Verwendung von ersten und zweiten Objekten, die so ausgestaltet sind, dass sie ein erstes und/oder zweites Signal identisch abstrahlen und/oder identisch empfangen und/oder abtasten. Insbesondere weisen sie baugleiche Sende- und/oder Empfangseinheiten und/oder baugleiche Abtastmittel, baugleiche Analog-Digital-Wandler, baugleiche Digital-Analog-Wandler, baugleiche Antennen, baugleiche Antennenanordnungen und/oder baugleiche Oszillatoren auf.

Insbesondere kann dadurch durch einmaliges Vermessen der Veränderung oder eines Empfangs der Flanke oder Testflanke, insbesondere unter Rekonstruktion der Testflanke aus der Vermessung mehrerer Wiederholungen des Sendens und/oder Empfangs der Testflanke, und mehrfache Verwendung der Kenntnis das Verfahren sehr effizient und schnell durchgeführt werden. Auch kann es dadurch ausreichen, die Mittel zum Vermessen und/oder zur Rekonstruktion nur am ersten oder zweiten Objekt vorzusehen, dies ist insbesondere vorteilhaft, wenn eines der Objekte ein tragbares Gerät, beispielsweise Schlüssel oder Mobiltelefon, ist oder das Verfahren mit zahlreichen ersten oder zahlreichen zweiten Objekten durchgeführt werden soll. Das versetzte Sampling von wiederholten Testsignalen ermöglicht es dabei, das Verfahren zuverlässig auch in komplexeren Umgebungen mit einfacher und preisgünstiger Hardware durchzuführen.

Insbesondere wird/werden pro erstem und/oder zweitem Signal, sofern es sich nicht um ein Testsignal handelt, nur weniger als 10 Abtastwerte pro Flanke genommen. Insbesondere wird/werden pro erstem oder zweiten Signal nur fünf oder weniger Abtastwerte pro Flanke genommen. Insbesondere werden die Abtastwerte von mindestens 5 Wiederholungen der Abstrahlung der Testflanke kombiniert und/oder gemeinsam verwendet, insbesondere zur Rekonstruktion der Testflanke.

Vorteilhafterweise wird die Zeitspanne zwischen erstens dem Empfang und/oder Sampling des mindestens einen ersten Signals am zweiten Objekt und/oder des mindestens einen ersten Abtastwertes in einer Flanke des ersten Signals am zweiten Objekt und zweitens dem Abstrahlen des Antwortsignals, das insbesondere ein zweites Signal darstellt, oder einer Flanke im zweiten Signal an das erste Objekt und/oder die Auswerteeinrichtung kommuniziert, insbesondere verschlüsselt, und/oder ist diese Zeitspanne dem ersten Objekt und/oder der Auswerteeinheit bekannt, insbesondere weil sie immer identisch gewählt wird.

Insbesondere wird der Verlauf der Flanke des ersten und/oder zweiten Signals vom ersten und zum zweiten Objekt und/oder umgekehrt, insbesondere verschlüsselt, kommuniziert und/oder die zeitliche Lage und/oder Phasenlage des zweiten analogen Signals am ersten Objekt vom ersten und zum zweiten Objekt kommuniziert.

Mit besonderem Vorteil beträgt die erste und/oder zweite Abtastrate mindestens das 1,8-fache, insbesondere mindestens das Zweifache, insbesondere mindestens das 3,8-fache, der Symbolrate des ersten und/oder zweiten analogen Signals, der ersten und/oder zweiten Frequenzbandbreite, der Frequenzbandbreite des dem Analog-Digital-Wandler zugeführten ersten oder zweiten Signals und/oder der Bandbreite, die zur Übertragung der mindestens einen ersten und/oder zweiten Information in der zur Übertragung der mindestens einen ersten bzw. zweiten Information verwendeten Zeit notwendig ist und/oder der Chiprate des ersten und/oder zweiten analogen Signals.

Mit Vorteil werden mehrere erste Abtastungen des ersten und/oder zweiten analogen Signals durchgeführt und verwendet und/oder der Verlauf der Flanke des ersten und/oder zweiten analogen Signals, Auflösung und/oder Bittiefe der ersten Abtastung des ersten und/oder zweiten analogen Signals so gewählt, dass über den Verlauf der Flanke des ersten und/oder zweiten analogen Signals mindestens zwei, insbesondere mindestens drei Abtastungen durchgeführt werden, die insbesondere unterschiedliche Abtastwerte aufweisen.

Mit besonderem Vorteil wird das Verfahren mindestens n-fach unter Verwendung von mindestens n unterschiedlichen Kombinationen erster Objekte und zweiter Objekte wiederholt, wobei an jeder der n Kombinationen als erstes oder zweites Objekt ein an allen Kombinationen beteiligtes einheitliches und/oder dediziertes Objekt beteiligt ist und das andere aus erstem und zweitem Objekt der Kombinationen so aus einer Menge von n Objekten gewählt ist, dass jedes der n Objekte, mindestens in einer der mindestens n Wiederholung des Verfahrens und/oder n Kombinationen ein erstes oder zweites Objekt darstellt. So wird abgesehen von maximal einem der n Objekte das Verfahren mindestens einmal unter Nutzung jedes der n Objekte als erstes oder zweites Objekt durchgeführt. Auch wird abgesehen von maximal einem der n Objekte das Verfahren mindestens einmal unter Nutzung jedes der n Objekte als zweites Objekt durchgeführt. Insbesondere handelt es sich bei dem einheitlichen und/oder dedizierten Objekt um ein tragbares und/oder mobiles Objekt und/oder um ein Mobiltelefon und/oder ein, insbesondere funkbasiertes, Authentifizierungsmittel, wie beispielsweise ein digitaler und/oder Funk-Schlüssel.

Mit besonderem Vorteil wird das Verfahren mindestens n-fach unter Verwendung von mindestens n unterschiedlichen Kombinationen erster Objekte und zweiter Objekte wiederholt, wobei die ersten und zweiten Objekte der Kombinationen so aus einer Menge von n Objekten gebildet sind, dass jedes der n Objekte, abgesehen von maximal einem der n Objekte, mindestens in einer der mindestens n Wiederholung ein erste Objekt und in mindestens einer anderen der mindestens n Wiederholungen ein zweites Objekt darstellt. So wird abgesehen von maximal einem der n Objekte das Verfahren mindestens einmal unter Nutzung jedes der n Objekte als erstes Objekt durchgeführt. Auch wird abgesehen von maximal einem der n Objekte das Verfahren mindestens einmal unter Nutzung jedes der n Objekte als zweites Objekt durchgeführt. Dabei wird insbesondere die Kommutation und/oder Variation einer Kombination als identisch zu der Kombination betrachtet. Bei den Kombinationen handelt es sich insbesondere um Kombinationen ohne Wiederholung.

In beiden zuvor geschilderten vorteilhaften Ausführungen werden insbesondere die bestimmten zeitliche Lagen des jeweiligen ersten analogen Signals, insbesondere zu einer Referenzzeit, und/oder daraus abgeleitete Informationen, insbesondere Entfernungen und/oder Positionen der und/oder zwischen den Objekten, n-Objekten und/oder einer Auswahl der n Objekte im und/oder an einem gemeinsamen Ort, insbesondere an einem der Objekte, insbesondere dem einheitlichen einheitlichen und/oder dedizierten Objekt, insbesondere am jeweiligen zweiten Objekt aller Wiederholungen an einem gemeinsamen Ort bereitgestellt und insbesondere verarbeitet. Die Bereitstellung kann beispielsweise durch eine Übertragung realisiert werden. Durch die zentrale Bereitstellungen können die relativen Abstände zentral bestimmt werden. Insbesondere wird bei jeder Ausstrahlung eines ersten Signals durch ein als erstes Objekt verwendetes der n Objekte das Signal von mindestens einem anderen und/oder an der Kombination nicht beteiligten, insbesondere von allen anderen, der n Objekte empfangen und das Verfahren für jedes der empfangen Objekte, insbesondere für jedes der nicht zur Ausstrahlung des ersten Signals verwendeten Objekte, als zweites Objekt durchgeführt zusammen mit dem zur Ausstrahlung verwendeten ersten Objekt. Dadurch lassen sich pro erstem Signal n-1 zeitliche Lagen bestimmen.

Insbesondere wird bei jeder Ausstrahlung eines zweiten Signals durch ein als zweites Objekt verwendetes der n Objekte das Signal von mindestens einem anderen und/oder an der Kombination nicht beteiligten, insbesondere von allen anderen, der n Objekte empfangen und das Verfahren für jedes der empfangen Objekte, insbesondere für jedes der nicht zur Ausstrahlung des zweiten Signals verwendeten Objekte, als erstes Objekt durchgeführt zusammen mit dem zur Ausstrahlung verwendeten zweiten Objekt.

Insbesondere sind die n Objekte ortsfest positioniert. Insbesondere ist ihre Position dem zweiten Objekt bekannt und/oder Insbesondere ist ihre Position an dem gemeinsamen Ort bekannt.

Insbesondere ist n mindestens gleich zwei, insbesondere größer als drei.

Mit besonderem Vorteil wird bei allen mindestens n Wiederholungen des Verfahrens das erfindungsgemäße Verfahren zusätzlich zwischen dem jeweiligen ersten Objekt (aus den n Objekten) der jeweiligen Wiederholung und einem bei allen mindestens n Wiederholungen einheitlichen und/oder dedizierten zweiten Objekt, das insbesondere nicht Teil der n Objekte ist, durchgeführt.

Insbesondere werden die bestimmten zeitliche Lagen des ersten analogen Signals zu einer Referenzzeit im und/oder am für alle Wiederholungen einheitlichen und/oder dedizierten zweiten Objekt an dem einen gemeinsamen Ort bereitgestellt und insbesondere verarbeitet und/oder ist der eine gemeinsame Ort das für alle Wiederholungen einheitliche und/oder dedizierte zweite Objekt.

Mit besonderem Vorteil werden bei allen mindestens n Wiederholungen des Verfahrens von einem weiteren bei allen mindestens n Wiederholungen einheitlichen und/oder dedizierten zweiten Objekt erstes und/oder zweites Signal empfangen, auch "mitgehört", das insbesondere nicht Teil der n Objekte ist. Dieses einheitliche Objekt nimmt insbesondere mindestens einen ersten Abtastwert jedes ersten und/oder zweiten Signals der mindestens n Wiederholungen des Verfahrens in einer steigenden oder fallenden Flanke des ersten und/oder zweiten analogen Signals. Insbesondere wird zusammen mit Kenntnis über den Verlauf der Flanke im ersten und/oder zweiten analogen Signal die zeitliche Lage des mindestens einen ersten Abtastwerts im einen ersten und/oder zweiten analogen Signal und dadurch insbesondere die zeitliche Lage des ersten und/oder zweiten analogen Signals zu einer Referenzzeit im und/oder am einheitlichen und/oder dedizierten Objekt bestimmt.

Dabei ist das für alle Wiederholungen einheitliche zweite Objekt insbesondere nicht ortsfest, insbesondere ist seine Position vor Durchführung des Verfahrens nicht bekannt. Insbesondere wird mittels des Verfahrens seine Position und/oder Orientierung, zumindest relativ zu den n Objekten, bestimmt. Insbesondere ist das für alle Wiederholungen einheitliche zweite Objekt ein tragbares Objekt, insbesondere ein Mobiltelefon.

Gelöst wird die Aufgabe auch durch ein Verfahren zur Sicherung eines Zugangssystems, insbesondere zu einem Kraftfahrzeug, aufweisend ein Autorisierungsmittel, insbesondere einen Funkschlüssel und/oder Handy, und ein Zugangskontrollmittel, insbesondere im Kraftfahrzeug, wobei das Zugangskontrollmittel, insbesondere ein Schloss, eine Barriere und/oder ein Sicherungsmittel steuert, wobei zwischen dem Autorisierungsmittel und dem Zugangskontrollmittel elektrische, magnetische oder elektromagnetische Signale, insbesondere Wellen, übertragen werden, wobei die Signallaufzeit und/oder Signalrundlaufzeit zwischen Autorisierungsmittel und Zugangskontrollmittel mittels dem vorstehenden Verfahren bestimmt wird, insbesondere mit einer oder mehreren der als vorteilhaft beschriebenen Ausgestaltungen, und bei Überschreiten einer vorbestimmten Signallaufzeit und/oder Signalrundlaufzeit oder einer vorbestimmten Entfernung zwischen Autorisierungsmittel und Zugangskontrollmittel und/oder bei Überschreiten einer vorbestimmten Abweichung von auf anderem Weg und/oder mittls anderem Verfahren bestimmter Signallaufzeit und/oder Signalrundlaufzeit oder Entfernung, insbesondere zwischen Autorisierungsmittel und Zugangskontrollmittel, der Zugang, Zutritt und/oder ein Öffnen, insbesondere durch das Zugangskontrollmittel verwehrt wird, wobei das Autorisierungsmittel ein erstes der beiden Objekte erstes und zweites Objekt und das Zugangskontrollmittel das zweite der beiden Objekte erstes und zweites Objekt darstellen. Dabei ist das Zugangssystem insbesondere so eingerichtet, dass das Autorisierungsmittel, insbesondere mittels der elektrischen, magnetischen oder elektromagnetischen Signale, das Zugangskontrollmittel dazu veranlassen kann, Zugang und/oder Zutritt zu gewähren, ein Öffnen durchzuführen und/oder ein Schloss, eine Barriere und/oder ein Sicherungsmittel zu öffnen. Das Zugangskontrollmittel und/oder Sicherungsmittel, kann auch durch Software und/oder einer Einheit aus Software und Hardware realisiert sein.

Gelöst wird die Aufgabe auch durch ein digitales Übertragungssystem, mit Mitteln zur Analyse der zeitlichen Lage und/oder Phasenlage, insbesondere zur Laufzeitmessung, Phasenmessung oder Synchronisierung, wobei das Übertragungssystem mindestens zwei Objekte aufweist und eingerichtet ist, mindestens eine erste, insbesondere digitale, Information in mindestens einem ersten analogen Signal codiert zwischen den zwei Objekten, insbesondere mittels mindestens einem ersten elektrischen, magnetischen oder elektromagnetischen Signal zu übertragen.

Gelöst wird die Aufgabe auch durch ein erstes Objekt, eingerichtet in Zusammenwirken mit einem zweiten Objekt das Verfahren durchzuführen und/oder ein Übertragungssystem zu bilden und/oder ein zweites Objekt eingerichtet in Zusammenwirken mit ersten zweiten Objekt das Verfahren durchzuführen und/oder ein Übertragungssystem zu bilden

Das erste Objekt und/oder das erste Objekt der zwei Objekte des Übertragungssystem ist insbesondere eingerichtet, zum Senden des mindestens einen ersten magnetischen, elektrischen oder elektromagnetischen Signals, und die mindestens eine erste Information in das mindestens eine erste analoge Signal mit einer ersten Frequenzbandbreite zu wandeln und mittels des mindestens einen ersten elektrischen, magnetischen oder elektromagnetischen Signals zu senden.

Das zweite Objekt und/oder das zweite Objekt der zwei Objekte des Übertragungssystem weist insbesondere mindestens einen ersten Analog-Digital-Wandler auf und/oder ist insbesondere eingerichtet, das mindestens eine erste elektrische, magnetische oder elektromagnetische Signal zu empfangen und insbesondere eine Umwandlung des mindestens einen ersten magnetischen, elektrischen oder elektromagnetischen Signals in empfangene erste digitale, Information, insbesondere mittels des mindestens einen ersten Analog-Digital-Wandlers, durchzuführen, wobei der mindestens eine erste Analog-Digital-Wandler eingerichtet ist, eine Abtastung mit einer ersten Abtastrate durchzuführen, wobei die erste Abtastrate insbesondere mindestens doppelt so groß und/oder schnell wie die erste Frequenzbandbreite, wie die Frequenzbandbreite des dem Analog-Digital-Wandler zugeführten Signal und/oder wie die Bandbreite, die zur Übertragung der mindestens einen ersten Information in der zur Übertragung der mindestens einen ersten Information verwendeten Zeit notwendig ist.

Insbesondere stellt das System, die Auswerteeinrichtung und/oder stellen die Objekte jeweils Hardware und Software Systeme dar, wobei sie insbesondere eine CPU und einen Speicher aufweisen, wobei insbesondere in dem Speicher ein Programm hinterlegt ist, um die beschriebenen Schritte, insbesondere ein erfindungsgemäßes Verfahren, durchzuführen und/oder anzusteuern, insbesondere in dem das Programm durch die CPU ausgeführt wird.

Mit Vorteil beträgt die Auflösung und/oder Bittiefe, also insbesondere die Feinheit der digitalen Umwandlung, der ersten Abtastung des ersten und/oder zweiten Signals und/oder des Analog-Digital-Wanlders mehr als 1 Bit, insbesondere mehr als 6 Bit, bevorzug mehr als 12 Bit. Dies erhöht die Genauigkeit des Systems.

Das System ist eingerichtet, mindestens einen ersten Abtastwert des mindestens einen ersten analogen Signals des mindestens einen ersten Analog-Digital-Wandlers in einer steigenden oder fallenden Flanke des mindestens einen ersten analogen Signals zu nehmen und diesen zu verwenden, um eine zeitlichen Lage und/oder Phasenlage dadurch zu bestimmen, dass aus dem mindestens einen ersten Abtastwert zusammen mit Kenntnis über den Verlauf der Flanke im mindestens einen ersten analogen Signal und/oder Phasenlage des mindestens einen ersten analogen Signals zu einer ersten Referenzzeit, auch Referenztakt, insbesondere am und/oder im zweiten Objekt, zu bestimmen und/oder in Abhängigkeit von der zeitlichen Lage des Signals, insbesondere im und/oder am zweiten Objekt, eine Aktion, insbesondere im und/oder am zweiten Objekt, durchzuführen, insbesondere so, dass vom zweiten Objekt ein erstes Antwortsignal abgestrahlt wird, insbesondere derart, dass zwischen der zeitlichen Lage und/oder Phasenlage des ersten analogen Signals, insbesondere im und/oder am zweiten Objekt, und des ersten Antwortsignals, insbesondere im und/oder am zweiten Objekt und/oder zwischen dem Empfang und/oder dem Abtasten des mindestens einen ersten Signals, insbesondere im und/oder am zweiten Objekt, und dem Abstrahlen des ersten Antwortsignals eine, insbesondere vorbestimmte, Beziehung besteht und/oder diese Beziehung an das erste Objekt und/oder eine Auswerteeinheit übertragen wird.

Insbesondere ist das System eingerichtet, ein erfindungsgemäßes Verfahren durchzuführen. Insbesondere weist es eine Auswerteeinheit auf. Insbesondere weisen das erste und das zweite Objekt jeweils mindestens eine Antenne, mindestens einen Oszillator und/oder Frequenzsynthesizer sowie mindestens einen Analog-Digital-Wandler auf. Vorteilhafterweise weisen sie jeweils auch einen Mischer auf, bei mehreren Antennen, insbesondere auch einen Switch oder Umschalter zur Umschaltung zwischen den Antennen, einen Kontroller für Abläufe inklusive Timer, einen Digital-Analog-Wandler, einen Eingangsverstärker, einen Ausgansgsverstärker und/oder eine CPU.

Gelöst wird die Aufgabe auch durch ein Zugangssystems, insbesondere zu einem Kraftfahrzeug, aufweisend ein Autorisierungsmittel, insbesondere einen Funkschlüssel und/oder Handy, und ein Zugangskontrollmittel, insbesondere im Kraftfahrzeug, wobei das Zugangskontrollmittel, insbesondere eingerichtet ist, ein Schloss, eine Barriere und/oder ein Sicherungsmittel zusteueren, wobei zwischen dem Autorisierungsmittel und dem Zugangskontrollmittel elektrische, magnetische oder elektromagnetische Signale, insbesondere Wellen, übertragen werden, wobei das Zugangssystem insbesondere ein erfindungsgemäßes System wie oben beschrieben ist und eingerichtet ist, die Signallaufzeit und/oder Signalrundlaufzeit zwischen Autorisierungsmittel und Zugangskontrollmittel, insbesondere mittels dem vorstehenden Verfahren, zu bestimmen, insbesondere mit einer oder mehreren der als vorteilhaft beschriebenen Ausgestaltungen, und eingerichtet ist, bei Überschreiten einer vorbestimmten Signallaufzeit und/oder Signalrundlaufzeit oder einer vorbestimmten Entfernung zwischen Autorisierungsmittel und Zugangskontrollmittel und/oder bei Überschreiten einer vorbestimmten Abweichung von auf anderem Weg oder mittels anderem Verfahren und/oder anderer Vorrichtung bestimmter Signallaufzeit und/oder Signalrundlaufzeit oder Entfernung den Zugang, Zutritt und/oder ein Öffnen zu verwehren, wobei das Autorisierungsmittel ein erstes der beiden Objekte erstes und zweites Objekt und das Zugangskontrollmittel das zweite der beiden Objekte erstes und zweites Objekt darstellen. Dabei ist das Zugangssystem insbesondere so eingerichtet, dass das Autorisierungsmittel, insbesondere mittels der elektrischen, magnetischen oder elektromagnetischen Signale, das Zugangskontrollmittel dazu veranlassen kann, Zugang und/oder Zutritt zu gewähren, ein Öffnen durchzuführen und/oder ein Schloss, eine Barriere und/oder ein Sicherungsmittel zu öffnen.

Gelöst wird die Aufgabe auch durch die Verwendung mindestens eines ersten Abtastwertes mindestens eines ersten analogen Signals, insbesondere mindestens eines ersten Analog-Digital-Wandlers, zum zeitlich aufgelösten Erfassen der Lage und/oder Phasenlage des ersten analogen Signals, insbesondere einer Flanke des ersten analogen Signals, zu einer ersten Referenzzeit, auch Referenztakt, insbesondere am und/oder im zweiten Objekt, bestimmt und/oder in Abhängigkeit von der zeitlichen Lage des Signals, insbesondere im und/oder am zweiten Objekt eine Aktion durchzuführen, insbesondere im und/oder am zweiten Objekt, insbesondere zum Abstrahlen eines ersten Antwortsignals vom zweiten Objekt, insbesondere derart, dass zwischen der zeitlichen Lage und/oder Phasenlage des ersten analogen Signals, insbesondere im und/oder am zweiten Objekt, und des ersten Antwortsignals, insbesondere einer Flanke des ersten Antwortsignals, insbesondere im und/oder am zweiten Objekt, und/oder zwischen dem Empfang und/oder dem Abtasten des mindestens einen ersten analogen Signals, insbesondere im und/oder am zweiten Objekt, und dem Abstrahlen des ersten Antwortsignals eine, insbesondere vorbestimmte, Beziehung besteht und/oder diese Beziehung an das erste Objekt und/oder eine Auswerteeinheit übertragen wird und/oder zum zeitlich aufgelösten Erfassen der Lage des mindestens einen ersten analogen Signals und/oder einer Flanke des ersten analogen Signals relativ zu einer zweiten Referenzzeit.

Mit Vorteil beinhaltet die Verwendung auch die Verwendung mindestens eines ersten Abtastwertes mindestens eines zweiten analogen Signals, auch als mindestens ein zweiter Abtastwert bezeichnet, insbesondere mindestens eines ersten Analog-Digital-Wandlers, zum zeitlich aufgelösten Erfassen der Lage und/oder Phasenlage des zweiten analogen Signals, insbesondere einer Flanke des zweiten analogen Signals, zu einer zweiten Referenzzeit, auch Referenztakt, insbesondere am und/oder im ersten Objekt, und/oder in Abhängigkeit von der zeitlichen Lage des Signals, insbesondere um im und/oder am ersten Objekt eine Aktion durchzuführen, insbesondere im und/oder am ersten Objekt, insbesondere zum Abstrahlen eines zweiten Antwortsignals vom ersten Objekt, insbesondere derart, dass zwischen der zeitlichen Lage und/oder Phasenlage des zweiten analogen Signals, insbesondere im und/oder am ersten Objekt, und des zweiten Antwortsignals, insbesondere im und/oder am ersten Objekt, und/oder zwischen dem Empfang und/oder dem Abtasten des mindestens einen zweiten analogen Signals, insbesondere im und/oder am ersten Objekt, und dem Abstrahlen des zweiten Antwortsignals eine vorbestimmte Beziehung besteht und/oder diese Beziehung an das zweite Objekt und/oder die Auswerteeinheit übertragen wird und/oder zum zeitlich aufgelösten Erfassen der Lage des mindestens einen zweiten analogen Signals und/oder einer Flanke des zweiten analogen Signals relativ zu einer zweiten Referenzzeit.

Mit besonderem Vorteil stellt das erste Antwortsignal mindestens ein zweites analoges Signal dar und/oder enthält das erste Antwortsignal mindestens ein zweites analoges Signal. Mit besonderem Vorteil stellt das zweite Antwortsignal mindestens ein erstes analoges Signal dar und/oder enthält das zweite Antwortsignal mindestens ein erstes analoges Signal. Auch alle vorteilhaften Ausgestaltungen des Verfahrens lassen sich auf die Verwendung übertragen. Die Verwendung kann insbesondere ein erfindungsgemäßes System benutzen. Das Verfahren kann insbesondere unter Verwendung eines erfindungsgemäßen Systems durchgeführt werden.

Vorteilhafterweise beinhaltet das Verfahren und/oder die Verwendung die Ermittlung der Entfernung zwischen dem ersten und zweiten Objekt aus der erste und/oder zweiten Signallaufzeit und/oder und/oder erste und/oder zweiten Phasenverschiebung und/oder Rundlaufsignallaufzeit und/oder Rundlaufphasenverschiebung.

Vorteilhafterweise beinhaltet die Verwendung die Bestimmung einer ersten Signallaufzeit und/oder ersten Phasenverschiebung des mindestens einen ersten analogen Signals vom ersten zum zweiten Objekt und/oder einer zweiten Signallaufzeit und/oder zweiten Phasenverschiebung des mindestens einen zweiten analogen Signals vom zweiten zum ersten Objekt und/oder einer Rundlaufsignallaufzeit und/oder Rundlaufphasenverschiebung des mindestens einen ersten analogen Signals und des mindestens einen zweiten analogen Signals vom ersten Objekt über das zweiten Objekt zum ersten Objekt bestimmt.

Vorteilhafterweise wird das erste analoge Signal an dem ersten Objekt erzeugt und von diesem mittels elektromagnetischer, elektrischer oder magnetischer Signale an ein zweites Objekt übertragen und/oder der Abtastwert an dem zweiten Objekt ermittelt und ist insbesondere die erste Referenzzeit eine Zeit am zweiten Objekt und/oder die zweite Referenzzeit eine Zeit am ersten Objekt und/oder erfolgt das Auslösen und/oder Durchführen der Aktion am zweiten Objekt und/oder wird insbesondere das erste Antwortsignal vom zweiten Objekt abgestrahlt und/oder ist insbesondere die zeitliche Beziehung zwischen der zeitlichen Lage des ersten analogen Signals am zweiten Objekt und des erstes Antwortsignals am zweiten Objekt gegeben.

Weitere vorteilhafte Ausgestaltungen und Vorteile sollen rein exemplarisch und nicht beschränkend anhand der nachfolgenden Skizzen weiter erläutert werden. Dabei zeigen:
- Figur 1:: eine schematische Darstellung eines Sende- und Empfangsmoduls aus dem Stand der Technik
- Figur 2:: eine Veranschaulichung des Verfahrens
- Figur 3:: eine Veranschaulichung der Aggregierung von Messwerten aus unterschiedlichen Symbolperioden

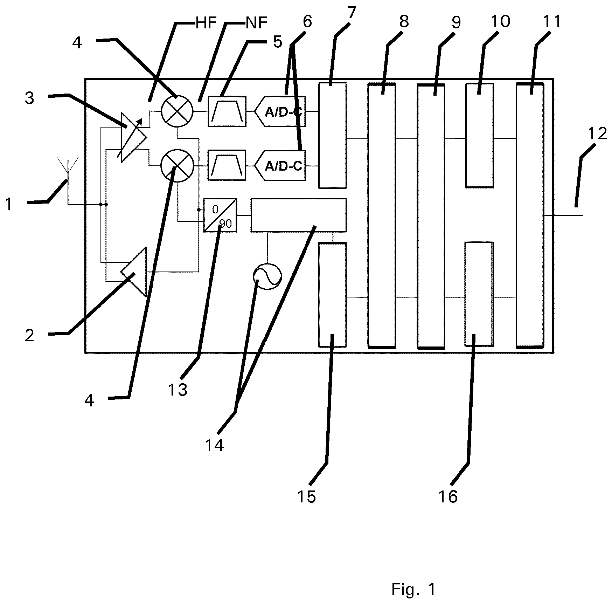

Figur 1 zeigt einen schematischen Aufbau eines Sende- und Empfangsmoduls aus dem Stand der Technik. Ein solches Modul ist beispielsweise durch den Chip CC25 von Texas Instruments gegeben. Ein solches Sende- und Empfangsmodul ist geeignet, mittels eines I&Q Verfahren Daten zu übertragen, beispielsweise unter Verwendung des Bluetooth Standards.

Gezeigt ist eine extern an den Chip angeschaltet Antenne 1. Die von der Antenne empfangenen Signale HF werden über den Eingangsverstärker 3 geleitet und dann in zwei Signale aufgeteilt. Diese werden zwei Mischern 4 zugeleitet und sodann als niederfrequente Signale NF jeweils über einen Bandpassfilter 5 an jeweils einen Analog-Digital-Wandler 6 geleitet. Einem der Mischer 4 wird darüber hinaus ein im Frequenzsynthesizer 14 erzeugtes Signal zugeleitet, während dem anderen Mischer 4 das Signal des Frequenzsynthesizer 14 erst nach Passage eines Phasenschiebers 13 zugeleitet wird. So lassen sich aus den Mischern 4 die niederfrequenten I und Q Signale NF erhalten. Nach dem Analog-Digital-Wandler 6 werden die I und Q Signale dann in digitaler Form dem dem Demodulator 7 zugeleitet und sodann über eine Fehlerkorrektur und Dekotiereinheit 8 an einen Pakethandler 9 und den Eingangsspeicher 10 übergeben. Von da aus gelangen sie an einen Schnittstellentreiber 11 durch diesen die Daten dann über den Eingang 12 bereitgestellt werden, beispielsweisezur Weiterverarbeitung mittels einer CPU.

Daten, die gesendet werden sollen, können über den Eingang 12 dem Schnittstellentreiber 11 übergegeben werden und werden sodann in einen Ausgangsspeicher 16 geschrieben und über den Pakethandler 9 an die Fehlerkorrektur und Codiereinheit 8 übergeben. Anschließend werden die so erzeugten niederfrequenten Signale NF mittels eines Modulators 15 und dem Frequenzsynthesizer 14 an als hochfrequente Signale HF den Sendeverstärker 2 und die Antenne 1 übergeben.

Sofern ein solches Modul für ein erfindungsgemäßes Verfahren, Verwendung oder System verwendet werden soll, wären neben den üblicherweise über den Eingang 12 bereitgestellten Empfangsdaten auch weitere Samplingwerte oder Abtastwerte der Analog-Digital-Wandler 6 abzugreifen, die zwar in der Regel im Analog-Digital-Wandler 6 erhoben werden, üblicherweise nur in den unmittelbar nachfolgenden Stufen verwendet, dann aber nicht weitergegeben oder weiterverwendet werden, beispielsweise nicht aus dem verwendeten Chip, hier beispielsweise über den Eingang 12, herausgeleitet werden.

Die Abtastwerte könnten zwar prinzipiell über den Eingang 12 ebenfalls bereitgestellt werden, was mittels einer Änderung der Firmware möglich sein könnte. Aber auch andere Daten Ein- und/oder Ausgänge sind denkbar. Grundsätzlich reicht die beinhaltete Hardware zusammen mit einer CPU und einer entsprechenden Software, insbesondere in einem Speicher, aber aus, dass erfindungsgemäße Verfahren umzusetzen oder ein Objekt eines erfindungsgemäßen Systems zu bilden.

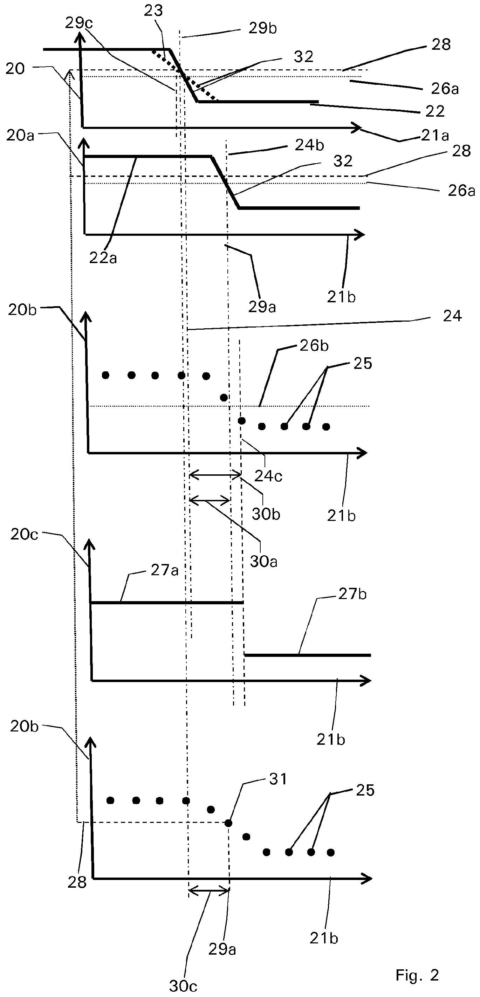

Figur 2 zeigt eine schematische Veranschaulichung des erfindungsgemäßen Verfahrens. Gezeigt sind übereinander mehrere Koordinatensysteme, die auf der horizontalen Achse jeweils eine Zeitachse zeigen und auf der vertikalen Achse jeweils die Ausprägung eines Signals darstellen. Dabei sind die einzelnen übereinander dargestellten Zeitachsen 21a, 21b zeitlich synchron angeordnet.

Das oberste Koordinatensystem mit der Zeitachse 21a zeigt ein analoges Signal 22 an einem ersten Objekt, das dieses Signal sendet. Die vertikale Achse 20 zeigt die Amplitude des Signals 22. Das Signal 22 verläuft zunächst konstant bei einem ersten Wert, bis es dann linear abfällt, um dann auf einem niedrigeren zweiten Wert konstant weiter zu verlaufen. Gezeigt ist darüber hinaus punktiert die mittlere Amplitude des Signals, nicht als Mittelwert 26a des Signals sondern als Mittelwert zwischen erstem und zweitem Wert. Gezeigt ist ausgehend von der Schnittstelle des Signals 22 und der mittleren Amplitude 26a eine vertikale Linie 24, die den Zeitpunkt der mittleren Amplitude am Sender darstellt.

Im darunter befindlichen Koordinatensystem, dem zweiten Koordinatensystem der Figur 2, ist der Signalverlauf 22a am Empfänger dargestellt in einem Koordinatensystem mit Zeitachse 21b und Amplitudenachse 20a. Der Signalverlauf 22a ist einer, der sich ohne weitere Störung und Verzerrung am Empfänger ergibt.

Zu erkennen ist, dass das Signal 22a am Empfänger um die Signallaufzeit 30a, zeitlicher Abstand zwischen Linie 29b und 29a, nach rechts verschoben ist. Gezeigt ist ebenfalls die mittlere Amplitude des Signals 26a, wie in der ersten Figur. Ausgehend von der Schnittstelle des Signals 22a und der mittleren Amplitude 26a ist eine vertikale Linie 24b gezeigt, die den Zeitpunkt der mittleren Amplitude am Empfänger darstellt.

Im Koordinatensystem darunter, im dritten Koordinatensystem, sind als Kreise Abtastungen mit Abtastwerten, die Amplitudenwerte darstellen, gezeigt, wobei die Abtastungen jeweils zu einem Zeitpunkt/während einer Zeitspanne erfolgen (Erstreckung der Kreise entlang der Zeitachse. Die Abtastungen sind die eines Analog-Digital-Wandlers und solche des des Signals 22a. Diese sind dargestellt in einem Koordinatensystem mit Zeitachse am Empfänger 21b und Abtastwert am Empfänger 20b.

Dargestellt ist auch die Entscheidungsschwelle 26b des Empfängers. Bei einem Abtastwert oberhalb dieser Entscheidungsschwelle 26b wird eine logische "eins" angenommen, bei einem Abtastwert unterhalb dieser Entscheidungsschwelle wird eine logische "null" angenommen. Hier dargestellt ist die Entscheidungsschwelle bei dem Wert der mittleren Amplitude. Sie kann aber auch bei einem anderen Wert liegen.

Im Koordinatensystem darunter, im vierten Koordinatensystem der Figur 2, sind auf der Achse der Ausprägung des digitalen Signals 20c gegen die Zeitachse am Empfänger 21b das aus den Abtastwerten und der Entscheidungsschwelle gewonnene digitale Signal 27a ("eins), 27b ("null") dargestellt. Zu erkennen ist, dass das digitale Signal von einer logischen eins 27a einer zu einer logischen null 27b abrupt abfällt.

Die Zeitspanne zwischen dem Zeitpunkt, an dem das Signal am Sender 22 die mittlere Amplitude 26a schneidet und dem Zeitpunkt, an dem das digitale Signal seinen Zustand von eins 27a auf null 27b ändert, ist als Doppelpfeil 30b veranschaulicht.

Es ist zu erkennen, dass sich abhängig von der Lage und der Abtastungen der Abtastwerte 25 des Signals 22a unterschiedliche Abweichungen zwischen den Doppelpfeil 30a und 30b ergeben, die die Genauigkeit der Laufzeitmessung begrenzen.

Im fünften Koordinatensystem der Figur 2, das erneut die Zeitachse am Empfänger 21b und die Amplitudenachse am Empfänger 20b zeigt sind erneut die Abtastwerte 25 wie im dritten Koordinatensystem der Figur 2 gezeigt. Veranschaulicht ist hier aber wie erfindungsgemäß aus einem Abtastwert 31 eine genauere Laufzeitmessung generiert werden kann: Unter Kenntnis des Signalverlaufs 22 am Sender kann der Zeitpunkt 29b ermittelt werden, an dem im Signal 22 dieser Wert 28 des Abtastwertes gegeben war. Dies ist durch den punktierten Pfeil zwischen fünftem und erstem Koordinatensystem veranschaulicht.

Die Zeitspanne zwischen dem Zeitpunkt 29b, zu dem der Wert 28 der Abtastung im Signal 22 am Sender gegeben war, und dem Zeitpunkt der Abtastung des Abtastwertes 31 mit dem Wert 28, veranschaulicht durch Doppelpfeil 30c, stellt eine sehr genaue Messung der Signallaufzeit zwischen Sender und Empfänger dar.

Diese Analyse kann für alle Abtastwerte in der Flanke, die also zwischen dem ersten und dem zweiten Wert liegen, also insbesondere in diesem Beispiel für den Abtastwert vor dem Abtastwert 31 und für den Abtastwert nach dem Abtastwert 31 wiederholt werden. Dadurch lässt sich, beispielsweise durch Mittelung der Ergebnisse, eine weitere deutliche Erhöhung der Genauigkeit erreichen.

Eine weitere Steigerung der Genauigkeit kann durch eine Abflachung der Flanke, wie im punktierten Signal 23 im ersten Koordinatensystem angedeutet, erreicht werden, aber auch durch eine Erhöhung der Abtastrate und der Auflösung der Abtastwerte (Bittiefe), aber auch durch Durchführung des Verfahrens an einer Mehr- oder Vielzahl von Flanken des Signals kann eine weitere Erhöhung der Genauigkeit erreicht werden. Das Prinzip lässt sich einfach auf eine Flanke der Phase und/oder Frequenz übertragen.

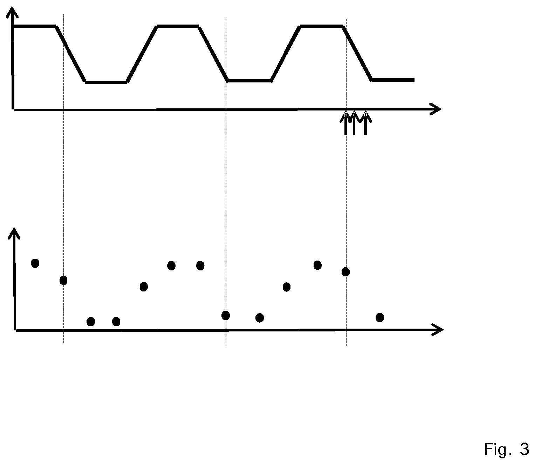

Figur 3 zeigt im oberen Teil ist ein Signal eines digitalen Datenübertragungssystems gezeigt, das alternierend zwischen zwei Zuständen, beispielsweise 0 und 1 wechselt, mit dazwischen liegenden Flanken. Im unteren Teil sind Messwerte (Abtastungen) des oberen Signals als dicke Punkte eingezeichnet. An den in einer fallenden Flanke liegenden Messpunkten sind zur Verdeutlichung der Lage im oberen Signal gestrichelte Linien in den oberen Teil geführt. Die Lage der Messpunkte, genommen an den aufeinander folgenden fallenden Flanken, in der Symbol- oder Chipperiode ist durch drei Pfeile im oberen Teil veranschaulicht. Man erkannt, dass durch die zeitversetzte Abtastung des Signals an unterschiedlichen Zeitpunkten der Symbol- oder Chipperiode bezüglich beispielsweise der drei fallenden Flanken die sich wiederholende fallende Flanke zeitlich sehr hoch aufgelöst erfasst werden kann.

### Bezugszeichenliste

- 1: Antenne
- 2: Sendeverstärker
- 3: Eingangsverstärker
- NF: Niederfrequenzsignal
- 4: Mischer
- HF: Hochfrequenzsignal
- 5: Bandpassfilter
- 6: Analog-Digital-Wandler
- 7: Demodulator
- 8: Fehlerkorrektur und Codierer und Decodierer
- 9: Pakethandler
- 10: Eingangs FiFo Speicher
- 11: Schnittstellentreiber
- 12: Eingang
- 13: Phasenschieber
- 14: Frequenzsynthesizer
- 15: Modulator
- 16: Ausgangs FiFo Speicher

- 20: Amplitudenachse Sender
- 20a: Amplitudenachse Empfänger
- 20b: Abtastwertachse Empfänger
- 20c: Achse des digitalen Signals
- 21a: Zeitachse am Sender
- 21b: Zeitachse am Empfänger
- 22: analoges Signal
- 22a: analoges Signal
- 23: analoges Signal
- 24: Zeitpunkt der mittleren Amplitude am Sender
- 24b: Zeitpunkt der mittleren Amplitude am Empfänger
- 24c: Zeitpunkt des die Entscheidungsschwelle unterschreitenden Messwerts
- 25: Messwert
- 26a: mittlere Amplitude
- 26b: Entscheidungsschwelle
- 27a: digitales Signal "1"
- 27b: digitales Signal "0"
- 28: Wert in einer Flanke
- 29a: Messzeit der Amplitude am Empfänger
- 29b: Zeit der gemessenen Amplitude am Sender
- 30a: Zeitspanne zwischen Senden und Empfang
- 30b: Zeitspanne zwischen Senden und Zeitpunkt des die Entscheidungsschwelle unterschreitenden Messwerts
- 30c: gemessene Zeitspanne
- 31: Abtastung auf Flanke
- 32: Flanke

## Patentansprüche

1. Verfahren zur Analyse der zeitlichen Lage und/oder Phasenlage mindestens eines ersten oder zweiten analogen Signals (22, 22a), insbesondere zur Laufzeitmessung, Phasenmessung und/oder Synchronisierung, in einem bidirektionalen digitalen insbesondere symbol- und/oder chipsynchronisiertem, Datenübertragungssystem, wobei mittels des Datenübertragungssystems mindestens eine erste digitale, eine erste Vielzahl von Bits, Symbolen und/oder Chips beinhaltende Information mit einer ersten Symbol- oder Chiprate in dem mindestens einem ersten analogen Signal (NF) (22) codiert von einem ersten zu einem zweiten Objekt oder in mindestens einem zweiten (22a) analogen auf Basis des ersten analogen Signals erzeugten Signal (HF) mit einer zweiten Symbol- oder Chiprate von einem ersten zu einem zweiten Objekt übertragen wird, und wobei mehrere erste Abtastungen (25, 31) des ersten analogen Signals (22) mit einer ersten Abtastrate, die mindestens das 1,8-fache der ersten Symbolrate und/oder Chiprate beträgt, oder mehrere zweite Abtastungen (25, 31) des zweiten analogen Signals (22a) mit einer zweiten Abtastrate, die mindestens das 1,8-fache der zweiten Symbolrate und/oder Chiprate beträgt, durchgeführt werden,
**dadurch gekennzeichnet, dass** mindestens ein erster Abtastwert (31) des mindestens einen ersten (22) oder zweiten analogen Signals (22a) am zweiten Objekt verwendet wird, um eine zeitlichen Lage und/oder Phasenlage des mindestens einen ersten analogen Signals (22) am zweiten Objekt
dadurch zu bestimmen, dass aus dem mindestens einen ersten Abtastwert des mindestens einen ersten oder zweiten analogen Signals (22a) am zweiten Objekt, der in einer steigenden oder fallenden Flanke (32) des mindestens einen ersten oder zweiten analogen Signals liegt, zusammen mit zumindest näherungsweiser Kenntnis über den Verlauf der Flanke im mindestens einen ersten oder zweiten analogen Signal am ersten Objekt die Lage des mindestens einen ersten Abtastwerts im mindestens einen ersten oder zweiten analogen Signal und dadurch die zeitliche Lage des ersten oder zweiten analogen Signals am zweiten Objekt bestimmt wird.

2. Verfahren nach Anspruch 1,wobei mittels des digitalen Datenübertragungssystems mindestens eine zweite Information in mindestens einem zweiten analogen Signal codiert vom zweiten zum ersten Objekt übertragen wird, wobei mindestens ein erster Abtastwert des mindestens einen zweiten analogen Signals am ersten Objekt, verwendet wird, um eine zeitlichen Lage und/oder Phasenlage dadurch zu bestimmen, dass aus dem mindestens einen ersten Abtastwert des mindestens einen zweiten analogen Signals, der in einer steigenden oder fallenden Flanke des mindestens einen zweiten analogen Signals liegt, zusammen mit Kenntnis über den Verlauf der Flanke im mindestens einen zweiten analogen Signal, insbesondere am zweiten Objekt, die zeitliche Lage des mindestens einen ersten Abtastwertes im mindestens einen zweiten analogen Signal und dadurch die zeitliche Lage des zweiten analogen Signals zu einer zweiten und/oder der ersten Referenzzeit bestimmt oder in Abhängigkeit von der zeitlichen Lage des Signals eine Aktion durchgeführt wird, insbesondere vom ersten Objekt ein zweites Antwortsignal abgestrahlt wird, insbesondere derart, dass zwischen der zeitlichen Lage und/oder der Phasenlage des zweiten analogen Signals und des zweiten Antwortsignals eine vorbestimmte und/oder kommunizierte Beziehung besteht.

3. Verfahren nach Anspruch 2, wobei eine erste Signallaufzeit und/oder erste Phasenverschiebung des mindestens einen ersten analogen Signals (22) vom ersten zum zweiten Objekt oder eine zweite Signallaufzeit und/oder zweite Phasenverschiebung des mindestens einen zweiten analogen Signals (22a) vom zweiten zum ersten Objekt oder eine Rundlaufsignallaufzeit und/oder Rundlaufphasenverschiebung des mindestens einen ersten analogen Signals und des mindestens einen zweiten analogen Signals vom ersten Objekt über das zweiten Objekt zum ersten Objekt bestimmt wird.

4. Verfahren nach Anspruch 3, wobei aus oder unter Verwendung der ersten und/oder zweiten Signallaufzeit und/oder ersten und/oder zweiten Phasenverschiebung und/oder Rundlaufsignallaufzeit und/oder Rundlaufphasenverschiebung eine Entfernung zwischen dem ersten und zweiten Objekt bestimmt wird.

5. Verfahren nach einem der vorstehenden Ansprüche, wobei in Abhängigkeit von der zeitlichen Lage des Signals am zweiten Objekt zu einer ersten Referenzzeit im und/oder am zweiten Objekt eine Aktion durchgeführt wird.

6. Verfahren nach einem der vorstehenden Ansprüche, wobei der Verlauf der Flanke des ersten (22) und/oder zweiten Signals (22a) vom ersten und zum zweiten Objekt und/oder umgekehrt kommuniziert wird und/oder die zeitliche Lage und/oder Phasenlage des zweiten analogen Signals am ersten Objekt vom ersten und zum zweiten Objekt kommuniziert wird und/oder die zeitliche Lage und/oder Phasenlage des ersten analogen Signals am zweiten Objekt vom zweiten und zum ersten Objekt kommuniziert wird und/oder der Zeitpunkt des Abstrahlens des ersten und/oder zweiten Signals und/oder die Zeitspanne zwischen dem Empfang und/oder Sampling des ersten Signals am zweiten Objekt und/oder des zweiten Signals am ersten Objekt vom ersten zum zweiten Objekt und/oder vom zweiten zum ersten Objekt kommuniziert wird und/oder diesem bekannt ist.

7. Verfahren nach einem der vorstehenden Ansprüche, wobei die Abtastrate des mindestens einen ersten und/oder zweiten Abtastwerts und/oder des mindestens einen Abtastwerts des ersten Signals und/oder zweiten Signals 12 Bit oder mehr beträgt.

8. Verfahren nach einem der vorstehenden Ansprüche, wobei der Verlauf der Flanke (32) des ersten und/oder zweiten analogen Signals (22, 22a), Auflösung und/oder Bittiefe der ersten Abtastung (31) des ersten und/oder zweiten analogen Signals so gewählt sind, dass über den Verlauf der Flanke des ersten und/oder zweiten Signals mindestens zwei, insbesondere mindestens drei Abtastungen durchgeführt werden, die insbesondere unterschiedliche Abtastwerte (31) aufweisen.

9. Verfahren nach einem der vorstehenden Ansprüche, wobei das Verfahren mindestens n-fach unter Verwendung von mindestens n unterschiedlichen Kombinationen erster Objekte und zweiter Objekte wiederholt wird, wobei an jeder der n Kombinationen als erstes oder zweites Objekt ein an allen Kombinationen beteiligtes einheitliches und/oder dediziertes Objekt beteiligt ist und das andere aus erstem und zweitem Objekt der Kombinationen so aus einer Menge von n Objekten gewählt ist, dass jedes der n Objekte, mindestens in einer der mindestens n Wiederholung des Verfahrens und/oder n Kombinationen ein erste oder zweites Objekt darstellt.

10. Verfahren nach dem vorstehenden Anspruch, wobei bei allen mindestens n Wiederholungen das Verfahren nach einem der Ansprüche 1 bis 9 zusätzlich zwischen dem jeweiligen ersten Objekt der jeweiligen Wiederholung und dem für alle Wiederholungen einheitlichen und/oder dedizierten zweiten Objekt durchgeführt wird und insbesondere die bestimmten zeitliche Lagen des ersten analogen Signals zu einer Referenzzeit im und/oder an einem für alle Wiederholungen einheitlichen und/oder dedizierten zweiten Objekt und/oder an einem gemeinsamen Ort bereitgestellt und insbesondere verarbeitet werden und insbesondere der eine gemeinsame Ort das für alle Wiederholungen einheitliche und/oder dedizierte zweite Objekt ist.

11. Verfahren zur Sicherung eines Zugangssystem aufweisend ein Autorisierungsmittel und ein Zugangskontrollmittel, wobei zwischen dem Autorisierungsmittel und dem Zugangskontrollmittel elektrisch, magnetisch oder elektromagnetisch Signale übertragen werden, wobei die Signallaufzeit, Signalrundlaufzeit und/oder Entfernung zwischen Autorisierungsmittel und ein Zugangskontrollmittel mittels einem der vorstehenden Verfahren bestimmt wird und bei Überschreiten einer vorbestimmten Signallaufzeit und/oder Signalrundlaufzeit und/oder einer vorbestimmten Entfernung und/oder bei Überschreiten einer vorbestimmten Abweichung von auf anderem Weg oder mittels anderem Verfahren bestimmter Signallaufzeit und/oder Signalrundlaufzeit und/oder Entfernung der Zugang, Zutritt und/oder ein Öffnen durch das Zugangskontrollmittel verwehrt wird.

12. Bidirektionales digitales Datenübertragungssystem, insbesondere symbol- und/oder chipsynchronisiert, mit Mitteln zur Analyse der zeitlichen Lage und/oder Phasenlage mindestens eines ersten oder zweiten analogen Signals (22, 22a), insbesondere zur Laufzeitmessung, Phasenmessung oder Synchronisierung, wobei das Datenübertragungssystem mindestens zwei Objekte aufweist und eingerichtet ist, mindestens eine erste digitale, eine erste Vielzahl von Bits, Symbolen und/oder Chips beinhaltende Information mit einer ersten Symbol- oder Chiprate in mindestens einem ersten analogen Signal (22) codiert oder in mindestens einem zweiten (22a) analogen auf Basis des ersten analogen Signals erzeugten Signal (HF) mit einer zweiten Symbol- oder Chiprate zwischen den zwei Objekten zu übertragen und mehrere erste Abtastungen des ersten analogen Signals mit einer ersten Abtastrate, die mindestens das 1,8-fache der ersten Symbolrate und/oder Chiprate beträgt, oder mehrere zweite Abtastungen des zweiten analogen Signals mit einer zweiten Abtastrate, die mindestens das 1,8-fache der zweiten Symbolrate und/oder Chiprate beträgt, durchzuführen,
**dadurch gekennzeichnet, dass** das System eingerichtet ist, mindestens einen ersten Abtastwert (31) des mindestens einen ersten oder zweiten analogen Signals (22, 22a) nach der Übertragung zwischen den zwei Objekten in einer steigenden oder fallenden Flanke (32) des mindestens einen ersten analogen Signals zu nehmen und diesen zu verwenden, um eine zeitlichen Lage und/oder Phasenlage des mindesten einen ersten oder zweiten analogen Signals dadurch zu bestimmen, dass aus dem mindestens einen ersten Abtastwert (31) zusammen mit zumindest näherungsweiser Kenntnis über den Verlauf der Flanke (32) im mindestens einen ersten oder zweiten analogen Signal am ersten Objekt die Lage des mindestens einen ersten Abtastwertes im mindestens einen ersten analogen Signal am zweiten Objekt und dadurch die Lage des ersten analogen Signals zu bestimmen.

## Claims

1. Method for analysing the temporal position and/or phase position of at least one first or second analogue signal (22, 22a), in particular for measuring the runtime, phase measurement and/or synchronisation in a bidirectional digital, in particular symbol- and/or chip-synchronised, data transmission system, wherein, by means of the data transmission system, at least one first digital piece of information containing a first plurality of bits, symbols and/or chips is encoded with a first symbol or chip rate in said at least one first analogue signal (NF) (22) with a first symbol or chip rate from a first to a second object, and wherein a plurality of first samples (25, 31) of the first analogue signal (22) with a first sampling rate, which is at least 1.8 times the first symbol rate and/or chip rate, or a plurality of second samples (25, 31) of the second analogue signal (22a) are taken at a second sampling rate which is at least 1.8 times the second symbol rate and/or chip rate, **characterised in that** at least one first sample value (31) of said at least one first (22) or second analogue signal (22a) at the second object is used to determine a temporal position and/or phase position of said at least one first analogue signal (22) at the second object by determining from said at least one first sample value of said at least one first or second analogue signal (22a) at the second object, which lies in a rising or falling edge (32) of said at least one first or second analogue signal, together with at least approximate knowledge of the course of the edge in said at least one first or second analogue signal at the first object, the position of said at least one first sample value in said at least one first or second analogue signal and thereby the temporal position of the first or second analogue signal at the second object is determined.

2. Method according to claim 1, wherein at least one second piece of information is transmitted from the second to the first object in at least one second analogue signal encoded by means of the digital data transmission system, wherein at least one first sample value of said at least one second analogue signal at the first object is used to determine a temporal position and/or phase position by determining the temporal position of said at least one first sample value in said at least one second analogue signal and thereby the temporal position of the second analogue signal relative to a second and/or the first reference time from said at least one first sample value of said at least one second analogue signal, which lies in a rising or falling edge of said at least one second analogue signal, together with knowledge of the course of the edge in said at least one second analogue signal, in particular at the second object, the temporal position of said at least one first sample value in said at least one second analogue signal and thereby the temporal position of the second analogue signal relative to a second and/or the first reference time is determined, or an action is performed depending on the temporal position of the signal, in particular a second response signal is emitted by the first object, in particular in such a way that there is a predetermined and/or communicated relationship between the temporal position and/or the phase position of the second analogue signal and the second response signal.

3. Method according to claim 2, wherein a first signal runtime and/or first phase shift of said at least one first analogue signal (22) from the first to the second object or a second signal runtime and/or second phase shift of said at least one second analogue signal (22a) from the second to the first object or a round-trip signal runtime and/or round-trip phase shift of said at least one first analogue signal and said at least one second analogue signal from the first object via the second object to the first object is determined.

4. Method according to claim 3, wherein a distance between the first and second objects is determined from or using the first and/or second signal runtime and/or first and/or second phase shift and/or round-trip signal runtime and/or round-trip phase shift.

5. Method according to one of the preceding claims, wherein an action is performed in the and/or at the second object depending on the temporal position of the signal at the second object at a first reference time.

6. Method according to one of the preceding claims, wherein the course of the edge of the first (22) and/or second signal (22a) from the first and to the second object and/or vice versa ( ) is communicated and/or the temporal position and/or phase position of the second analogue signal at the first object is communicated from the first and to the second object and/or the temporal position and/or phase position of the second analogue signal at the second object is communicated from the second to the first object and/or the time of emission of the first and/or second signal and/or the time span between the reception and/or sampling of the first signal at the second object and/or the second signal at the first object is communicated from the first to the second object and/or from the second to the first object and/or is known to the first object.

7. Method according to one of the preceding claims, wherein the sampling rate of said at least one first and/or second sample value and/or of said at least one sample value of the first signal and/or second signal is 12 bits or more.

8. Method according to one of the preceding claims, wherein the course of the edge (32) of the first and/or second analogue signal (22, 22a), resolution and/or bit depth of the first sampling (31) of the first and/or second analogue signal are selected such that at least two, in particular at least three, samples are performed over the course of the edge of the first and/or second signal, which samples in particular have different sample values (31).

9. Method according to one of the preceding claims, wherein the method is repeated at least n times using at least n different combinations of first objects and second objects, wherein each of the n combinations involves a uniform and/or dedicated object that is involved in all combinations as the first or second object, and the other of the first and second objects of the combinations is selected from a set of n objects such that each of the n objects represents a first or second object in at least one of said at least n repetitions of the method and/or n combinations.

10. Method according to the preceding claim, wherein in all at least n repetitions, the method according to one of claims 1 to 9 is additionally carried out between the respective first object of the respective repetition and the second object that is uniform and/or dedicated for all repetitions, and in particular the specific temporal positions of the first analogue signal are provided at a reference time in and/or at a second object that is uniform and/or dedicated for all repetitions and/or at a common location, and in particular the one common location is the second object that is uniform and/or dedicated for all repetitions.

11. Method for securing an access system comprising an authorisation means and an access control means, wherein signals are transmitted electrically, magnetically or electromagnetically between the authorisation means and the access control means, wherein the signal runtime, signal round-trip time and/or distance between the authorisation means and an access control means are determined by means of one of the above methods, and if a predetermined signal runtime and/or signal round-trip time and/or a predetermined distance is exceeded, and/or if a predetermined deviation from the signal runtime and/or signal round-trip time and/or distance determined by other means or by means of another method is exceeded, access, entry and/or opening by the access control means is denied.

12. Bidirectional digital data transmission system, in particular symbol- and/or chip-synchronised, with means for analysing the temporal position and/or phase position of at least one first or second analogue signal (22, 22a), in particular for measuring the transit time, phase measurement or synchronisation, wherein the data transmission system has at least two objects and is set up to transmit at least one first digital piece of information containing a first plurality of bits, symbols and/or chips at a first symbol or chip rate in at least one first analogue signal (22) or in at least one second analogue signal (22a) generated on the basis of the first analogue signal (HF) generated on the basis of the first analogue signal, and to transmit a plurality of first samples of the first analogue signal at a first sampling rate which is at least 1.8 times the first symbol rate and/or chip rate, or a plurality of second samples of the second analogue signal at a second sampling rate which is at least 1.8times the second symbol rate and/or chip rate, **characterised in that** the system is set up to transmit at least one first sample value (31) of said at least one first or second analogue signal (22, 22a) after transmission between the two objects in a rising or falling edge (32) of said at least one first analogue signal and to use this to determine a temporal position and/or phase position of said at least one first or second analogue signal by determining from said at least one first sample value (31) together with at least approximate knowledge of the course of the edge (32) in said at least one first or second analogue signal at the first object, to determine the position of said at least one first sample value in said at least one first analogue signal at the second object and thereby the position of the first analogue signal.

## Revendications

1. Procédé d'analyse de la position temporelle et/ou de la position de phase d'au moins un premier ou un second signal analogique (22, 22a), en particulier pour la mesure du temps de marche, la mesure de phase et/ou synchronisation, dans un système de transmission de données numérique bidirectionnel, en particulier synchronisé par symboles et/ou puces, dans lequel, au moyen du système de transmission de données, au moins une première information numérique contenant une première pluralité de bits, de symboles et/ou de puces est codée avec un premier débit de symboles ou de puces dans ledit au moins un premier signal analogique (NF) (22) avec un premier débit de symboles ou de puces d'un premier objet vers un second objet ou dans au moins un second signal analogique (22a) (HF) généré sur la base du premier signal analogique avec un second débit de symboles ou de puces d'un premier objet vers un second objet, et dans lequel plusieurs premiers échantillons (25, 31) du premier signal analogique (22) avec un premier débit d'échantillonnage, qui est au moins 1,8 fois supérieur au premier débit de symboles et/ou au premier débit de puces, ou plusieurs seconds échantillonnages (25, 31) du second signal analogique (22a) sont effectués avec un second débit d'échantillonnage qui est au moins 1,8 fois supérieur au second débit de symboles et/ou au second débit de puces, **caractérisé en ce qu'**au moins une première valeur d'échantillonnage (31) dudit au moins un premier (22) ou second signal analogique (22a) sur le second objet est utilisée pour déterminer une position temporelle et/ou une position de phase dudit au moins un premier signal analogique (22) sur le second objet **en ce que**, à partir de ladite au moins une première valeur d'échantillonnage dudit au moins un premier ou second signal analogique (22a) sur le second objet, qui se trouve dans un front montant ou descendant (32) dudit au moins un premier ou second signal analogique, est utilisée, conjointement avec au moins une connaissance approximative du tracé du front dans ledit au moins un premier ou second signal analogique sur le premier objet, pour déterminer la position de ladite au moins une première valeur d'échantillonnage dans ledit au moins un premier ou second signal analogique et ainsi la position temporelle du premier ou second signal analogique sur le second objet.

2. Procédé selon la revendication 1, dans lequel au moins une second information est transmise du second objet au premier objet au moyen du système de transmission de données numériques, codée dans au moins un second signal analogique, au moins une première valeur d'échantillonnage dudit au moins un second signal analogique sur le premier objet est utilisée pour déterminer une position temporelle et/ou une position de phase en ce que, à partir de ladite au moins une première valeur d'échantillonnage dudit au moins un second signal analogique, qui se trouve dans un front montant ou descendant dudit au moins un second signal analogique, conjointement avec la connaissance du tracé du front dans ledit au moins un second signal analogique, en particulier sur le second objet, la position temporelle de ladite au moins une première valeur d'échantillonnage dans ledit au moins un second signal analogique et, de ce fait, la position temporelle du second signal analogique par rapport à un second et/ou au premier temps de référence est déterminée ou une action est effectuée en fonction de la position temporelle du signal, en particulier un second signal de réponse est émis par le premier objet, en particulier de telle sorte qu'il existe une relation prédéterminée et/ou communiquée entre la position temporelle et/ou la position de phase du second signal analogique et du second signal de réponse.

3. Procédé selon la revendication 2, dans lequel un premier temps de marche du signal et/ou un premier déphasage dudit au moins un premier signal analogique (22) du premier vers le second objet ou un second temps de marche du signal et/ou un second déphasage dudit au moins un second signal analogique (22a) du second au premier objet ou un temps de marche de signal circulaire et/ou un déphasage circulaire dudit au moins un premier signal analogique et dudit au moins un second signal analogique du premier objet via le second objet au premier objet est déterminé.

4. Procédé selon la revendication 3, dans lequel une distance entre le premier et le second objet est déterminée à partir ou en utilisant le premier et/ou le second temps de marche du signal et/ou le premier et/ou le second déphasage et/ou le temps de marche du signal aller-retour et/ou le déphasage aller-retour.

5. Procédé selon l'une des revendications précédentes, dans lequel une action est effectuée en fonction de la position temporelle du signal au niveau du second objet par rapport à un premier temps de référence dans et/ou au niveau du second objet.

6. Procédé selon l'une des revendications précédentes, dans lequel le tracé du front du premier (22) et/ou du second signal (22a) est communiqué du premier et vers le second objet et/ou de l' e inversé et/ou la position temporelle et/ou la position de phase du second signal analogique au niveau du premier objet est communiquée du premier et vers le second objet et/ou la position temporelle et/ou la position de phase du premier signal analogique au niveau du second objet est communiquée du second objet vers le premier objet et/ou le moment de l'émission du premier et/ou du second signal et/ou l'intervalle de temps entre la réception et/ou l'échantillonnage du premier signal au niveau du second objet et/ou du second signal au niveau du premier objet est communiqué du premier objet vers le second objet et/ou du second objet vers le premier objet et/ou est connu de celui-ci.

7. Procédé selon l'une des revendications précédentes, dans lequel le taux d'échantillonnage d'au moins une première et/ou second valeur d'échantillonnage et/ou d'au moins une valeur d'échantillonnage du premier signal et/ou du second signal est de 12 bits ou plus.

8. Procédé selon l'une des revendications précédentes, dans lequel la courbe du front (32) du premier et/ou du second signal analogique (22, 22a), la résolution et/ou la profondeur de bits du premier échantillonnage (31) du premier et/ou du second signal analogique sont choisies de telle sorte qu'au moins deux, en particulier au moins trois échantillonnages, qui présentent en particulier des valeurs d'échantillonnage différentes (31), sont effectués sur le tracé du front du premier et/ou du second signal.

9. Procédé selon l'une des revendications précédentes, le procédé étant répété au moins n fois en utilisant au moins n combinaisons différentes de premiers objets et de seconds objets, dans lequel, dans chacune des n combinaisons, un objet uniforme et/ou dédié participant à toutes les combinaisons est impliqué en tant que premier ou second objet, et l'autre des premier et second objets des combinaisons est sélectionné parmi un ensemble de n objets de telle sorte que chacun des n objets représente un premier ou un second objet dans au moins une des au moins n répétitions du procédé et/ou n combinaisons.

10. Procédé selon la revendication précédente, dans lequel, pour toutes les au moins n répétitions, le procédé selon l'une des revendications 1 à 9 est en outre mis en œuvre entre le premier objet respectif de la répétition respective et le second objet uniforme et/ou dédié pour toutes les répétitions, et en particulier les positions temporelles déterminées du premier signal analogique sont mises à disposition et en particulier traitées par rapport à un temps de référence dans et/ou à un second objet uniforme et/ou dédié pour toutes les répétitions et/ou à un emplacement commun, et en particulier le traitement est effectué et en particulier l'emplacement commun est le second objet uniforme et/ou dédié pour toutes les répétitions.

11. Procédé pour sécuriser un système d'accès comprenant un moyen d'autorisation et un moyen de contrôle d'accès, des signaux étant transmis entre le moyen d'autorisation et le moyen de contrôle d'accès de manière électrique, magnétique ou électromagnétique, le temps de marche du signal, le temps de rotation du signal et/ou la distance entre le moyen d'autorisation et un moyen de contrôle d'accès sont déterminés au moyen de l'un des procédés ci-dessus et, en cas de dépassement d'un temps de marche du signal et/ou d'un temps de rotation du signal et/ou d'une distance prédéterminés et/ou en cas de dépassement d'un écart prédéterminé par rapport au temps de marche du signal et/ou au temps de rotation du signal et/ou à la distance déterminés par un autre moyen ou au moyen d'un autre procédé, l'accès, l'entrée et/ou l'ouverture par le moyen de contrôle d'accès est refusé.

12. Système de transmission de données numérique bidirectionnel, en particulier synchronisé par symbole et/ou par puce, avec des moyens pour analyser la position temporelle et/ou la position de phase d'au moins un premier ou un second signal analogique (22, 22a), en particulier pour mesurer le temps de marche, mesure de phase ou synchronisation, le système de transmission de données comportant au moins deux objets et étant conçu pour transmettre au moins une première information numérique, une première pluralité d'informations contenant des bits, des symboles et/ou des puces avec un premier débit de symboles ou de puces dans au moins un premier signal analogique (22) ou dans au moins un second signal analogique (22a) généré sur la base du premier signal analogique (HF) généré sur la base du premier signal analogique, avec un second débit de symboles ou de puces, entre les deux objets, et de réaliser plusieurs premiers échantillonnages du premier signal analogique avec un premier débit d'échantillonnage qui est au moins 1,8 fois supérieur au premier débit de symboles et/ou au premier débit de puces, ou plusieurs seconds échantillonnages du second signal analogique avec un second débit d'échantillonnage qui est au moins 1,8 fois le second débit de symboles et/ou le second débit de puces, **caractérisé en ce que** le système est conçu pour transmettre au moins une première valeur d'échantillonnage (31) dudit au moins un premier ou second signal analogique (22, 22a) après la transmission entre les deux objets dans un front montant ou descendant (32) dudit au moins un premier signal analogique et de l'utiliser pour déterminer une position temporelle et/ou une position de phase dudit au moins un premier ou second signal analogique en combinant ladite au moins une première valeur d'échantillonnage (31) avec au moins une connaissance approximative du tracé du front (32) dans au moins un premier ou second signal analogique sur le premier objet, la position d'au moins une première valeur d'échantillonnage dans au moins un premier signal analogique sur le second objet et, de ce fait, la position du premier signal analogique.
